(19)

Europäisches
Patentamt
European
Patent Office
Office européen
des brevets

(11) **EP 2 176 758 B1**

(12) **EUROPEAN PATENT SPECIFICATION**

(45) Date of publication and mention
of the grant of the patent:
**10.11.2010 Bulletin 2010/45**

(21) Application number: **08776581.4**

(22) Date of filing: **01.07.2008**

(51) Int Cl.:
***G06F 11/10*** *(2006.01)*      ***H03M 13/11*** *(2006.01)*

(86) International application number:
**PCT/IE2008/000071**

(87) International publication number:
**WO 2009/004601 (08.01.2009 Gazette 2009/02)**

(54) **GENERATION OF PARITY-CHECK MATRICES**

ERZEUGUNG VON PARITÄTSPRÜFMATRIZEN

GÉNÉRATION D'UNE MATRICE DE CONTRÔLE DE PARITÉ

(84) Designated Contracting States:
**AT BE BG CH CY CZ DE DK EE ES FI FR GB GR
HR HU IS IT LI LT LU LV MC MT NL NO PL PT RO
SE SI SK TR**

(30) Priority: **02.07.2007 US 929533 P**

(43) Date of publication of application:
**21.04.2010 Bulletin 2010/16**

(73) Proprietor: **Technology from Ideas Limited
Unit 3B, Cleaboy
Business Park
Waterford (IE)**

(72) Inventors:
 • **MCEVOY, Paul
 Waterford (IE)**

 • **WENUS, Jakub
 Dublin 8 (IE)**
 • **HURLEY, Ted
 Galway (IE)**

(74) Representative: **Weldon, Michael James et al
John A. O'Brien & Associates
Third Floor,
Duncairn House,
14 Carysfort Avenue
Blackrock, Co. Dublin (IE)**

(56) References cited:
**WO-A-02/103631      WO-A-2006/117769**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

<u>INTRODUCTION</u>

<u>Field of the Invention</u>

The invention relates to generation of low-density parity-check (LDPC) matrices of the Group-Ring type for error correction coding.

<u>Prior Art Discussion</u>

Error correcting codes are used to protect data from errors occurring during communication over noisy channels or storage on data storage media. In recent years it has been found that iteratively decoded codes such as 'turbo codes' and 'low-density parity-check (LDPC)' codes can perform very close to the fundamental limit of reliable communication, so called 'Shannon limit', when operated on sufficiently large blocks of data. However, wider deployment of these codes, and especially LDPC codes, is hindered by their relatively large encoding and decoding complexity. Moreover, the most efficient LDPC codes are represented by large matrices generated using pseudo-random methods. Such matrices cannot be recreated algebraically so large amounts of memory are necessary to store them. Therefore, there is a need of reducing the LDPC coding complexity and increasing the code performance for smaller blocks of data (applicable to wireless communications) using fully deterministic matrix generation methods.

Large pseudo-random matrices are often not practical for low-power devices such as mobile devices, where the processing power and the memory requirements significantly affect battery power and cost. Hence, the approach for such devices has been to use convolutional codes, for example in the telecommunication standards GSM and 3G, for encoding as they require less processing power and can be implemented on an ASIC as opposed to needing a DSP.

W02006/117769 describes an approach to generating code matrices in which there is group and ring selections, forming a group-ring RG, selecting elements from the RG, and generating the encoding and decoding matrices. A problem is that the Group-Ring is an infinite set of matrices, from which a suitable element must be chosen. Guidance is not given as to how to choose an element having properties specific to its intended use.

Also, non-Group-Ring approaches have been employed to generation of LDPC parity check matrices, such as described in US2007/0033480 and WO2004/019268.

WO02/103631 (Flarion) describes decoding of codewords using message passing decoding techniques.

The invention is directed towards achieving improved performance and memory organization for generation of LDPC parity check matrices.

<u>SUMMARY OF THE INVENTION</u>

According to the invention, which is defined in detail in the appended independent claims 1 and 10, there is provided a method performed by a data processor of an electronic or optical circuit for generation of a Group Ring parity check matrix H for error correction coding, the method comprising the steps of:

(a) choosing a suitable Group-Ring matrix structure containing sub-matrices;
(b) providing initial vectors for each of the sub-matrices by choosing suitable Ring and suitable Group elements;
(c) filling the sub-matrices from each vector according to a row-filling scheme;
(d) filling the Group-Ring matrix structure from the sub-matrices to provide a Group-Ring matrix RG; and
(e) transposing the RG matrix to create the parity matrix H,

wherein the method comprises the further step (f) of deleting columns from the matrix RG, and the number of columns deleted is determined by a desired value for the rate, the rate being the target ratio of data in to data out.

Preferably, in the step (a) the RG matrix has N square sub-matrices in each row and column, N being an integer number, and preferably N is a power of 2.

Preferably, in the step (a) the RG matrix structure is such that the RG matrix size equals the codeword length. Also, the number of elements across all of the sub matrices in step (b) preferably provides a low density parity check (LDPC) matrix.

In one embodiment, in the step (b) the differences between elements are never repeated, either within a single vector or between vectors, and preferably in the step (b) cyclic spacing, defined by length of vector n minus difference, between elements are never repeated, either within a single vector or between vectors.

In one embodiment, in the step (b) the number of vectors equals the codeword length divided by the number of sub-matrices, and in the step (b) the selection of Group Ring elements constituting the vectors is performed in a pseudo-random way.

In one embodiment, in the step (b) the vector elements are chosen within the range of indices of a given sub-matrix from 0 to n-1 inclusive, where n is defined as the code size divided by N.

In one embodiment, the step (b) comprises transforming the vectors to a binary form in which each element defines position of 1 in a row vector of n elements.

Preferably, the step (c) comprises filling the sub-matrices by use of a linear cyclic operation, wherein each row of a sub matrix is filled from the previous row with the positions cycled forward or backward by an integer number, and preferably the step (c) comprises filling the sub-matrices, wherein each row of a sub-matrix is filled from the previous row with the positions cycled forward or backward by an integer value dynamically determined by an equation.

In one embodiment, the step (f) is performed in conjunction with steps (a), (b), (c), and (d) in order to achieve a good distance by ensuring that the RG matrix does not have any zero weight columns or rows and a target column weight distribution consisting of a heavy distribution around low column weight values with occasional high weight values is achieved.

Preferably, the step (d) comprises making a cyclic arrangement of the sub-matrices, and the selection of which columns to delete in the step (f) is determined by means of an algebraic pattern which is consistent with rules used for vector creation.

In one embodiment, the step (t) is performed in conjunction with steps (a), (b), (c), (d), and (e) in order to ensure that the RG matrix is invertible and that the parity-check matrix does not have any zero weight columns or rows, and preferably step (f) is performed to remove or minimise short cycles such as 6-cycle and 8-cycle loops relating parity and data bits.

In one embodiment, step (f) comprises the sub-steps of:

(i) determining a difference set of group elements to be taken with non-zero support to check a Group Ring code,
(ii) choosing the group elements of the check code, so that the difference set does not contain repeated elements,
(iii) using the group ring element whose group elements with non-zero support have a difference set with no repeated (group) elements, and
(iv) choosing the rate by deciding which rows of the matrix corresponding to the group ring element are to be deleted.

In another aspect, the invention provides an electronic or optical circuit adapted to generate a parity check matrix H for error correction coding in any method defined above.

In a further aspect, the invention provides a method for data encoding or decoding, the method comprising the steps of:

(i) receiving initial vectors calculated from row vectors of a parity check matrix H generated by any method defined above:
(ii) cyclic shifting the vectors to generate a desired output row of the parity check matrix H;
(iii) re-arranging the operation order of the vectors depending on the RG matrix structure and the chosen row;
(iv) operating on the vectors on information to be encoded; and
(v) repeating steps (ii) to (iv) for the next row of the parity check matrix H.

In one embodiment, for step (ii) the circuit adds an additional cyclic shift each time a deleted column is reached, thus creating a row based on the next non-deleted column. In one embodiment, for steps (i) and (ii) vectors are converted into counters, each of which stores the location of an element of a vector.

In one embodiment, a counter tracks the position of each of the 1s directly and the counter block sizes are integer powers of 2 as the binary counters automatically reset themselves at the end of each cycle. In one embodiment, the counters are incremented or decremented by a desired shift corresponding to the next desired row.

In one embodiment, step (ii) is performed by a shift register.

In another aspect, the invention provides an electronic or optical circuit for encoding or decoding, the circuit being adapted to perform the steps of any method defined above after receiving the initial vectors form row vectors of a parity check matrix.

The invention also provides a communication device for generating a forward error correction data stream, the device comprising any circuit defined above.

In a further aspect, the invention provides a method of data encoding or decoding using an LDPC Group Ring parity check matrix, the method providing reduced memory storage complexity, wherein diagonal matrix elements of the protograph entries being cyclic shifts of the previous row, are stored within adjacent memory addresses, allowing variable node and check node processes to access a reduced number of larger memories. In one embodiment, a DPC encoder or decoder vector serial architecture circuit is adapted to perform this method.

In another aspect, a parallel architecture circuit operates on whole row or column protograph entries in each cycle, and preferably the circuit is adapted to carry out the method, wherein the circuit operates on multiple whole row or column protograph entries in each cycle. In another aspect the circuit is adapted to use Layered Belief Propagation by using the ring circulant nature of the matrix to define the layers, or by mapping the rows in the expansion matrix onto the layers, and then using the check/variable update from one layer on the next layers, thus achieving an enhanced decoder convergence time.

The invention also provides a computer readable memory used to store a program for performing any method defined above when executing on a digital processor.

Detailed Description of the Invention

The invention will be more clearly understood from the following description of some embodiments thereof, given by way of example only with reference to the accompanying drawings in which:-

Fig. 1 is a diagram illustrating operation of encoding and decoding circuits of the invention;

Fig. 2(a) is a diagram illustrating four Group Ring (RG) element vectors, and Fig. 2(b) is a flow diagram showing generation of an RG matrix from the vectors;

Fig. 3 shows transformation of the RG matrix to a parity-check matrix;

Fig. 4 shows two different RG matrices generated from the same initial vectors;

Fig. 5 is a set of plots showing performance comparisons;

Fig. 6 shows two RG matrices and corresponding parity-check matrices;

Fig. 7 is a set of plots showing performance comparisons;

Fig. 8 illustrates row-filling patterns;

Fig. 9 shows histograms for matrix characteristics;

Fig. 10 is a set of plots of performance comparisons;

Fig. 11 shows two different row-filling patterns;

Fig. 12 shows an RG matrix and three corresponding parity-check matrices;

Fig. 13 shows histograms for matrix characteristics;

Fig. 14 is a set of plots showing performance comparisons;

Fig. 15 shows further row-filling patterns;

Figs. 16 and 17 are representations of RG matrices during in-line LDPC matrix generation;

Fig. 18 is a block diagram of a hardware circuit for in-line matrix generation;

Fig. 19 is a block diagram showing an alternative shift register arrangement for the hardware;

Figs. 20 to 23 are hardware diagrams for circuits of the invention in various embodiments; and

Figs. 24 to 27 are plots illustrating benefits arising from the invention.

Description of the Embodiments

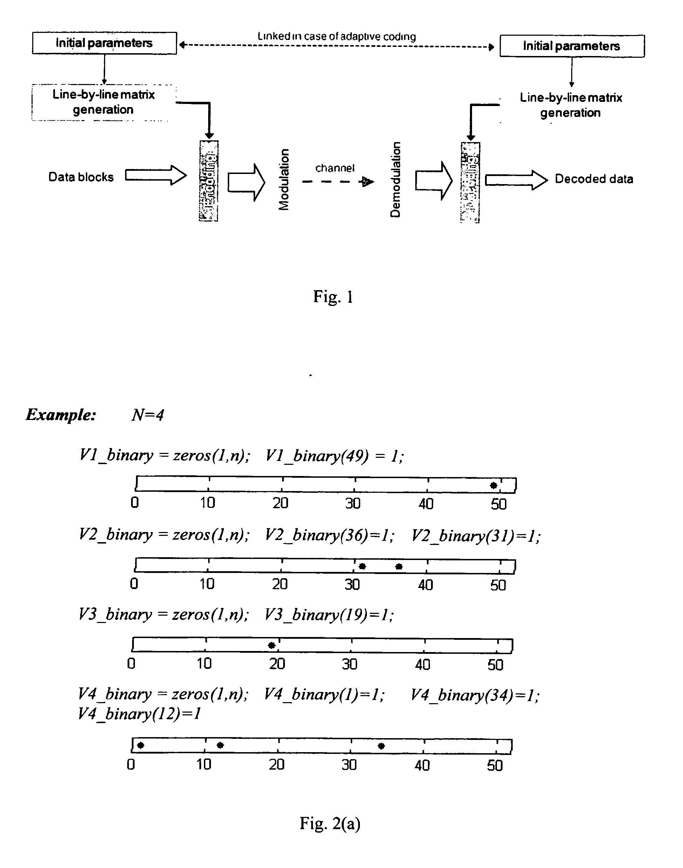

Referring to Fig. 1 a circuit of the invention performs row-by-row matrix generation for encoding of data blocks before modulation. Another circuit of the invention is in the receiver, performing row-by-row matrix generation for decoding.

The circuits perform fast algebraic generation of high performance low density parity check (LDPC) matrices suitable for use in a wide range of error correction coding and decoding (ECC) applications. Circuit operation is based on a mathematical Cyclic Ring method that enables matrices of any size to be generated from a simple set of initial parameters, based on user-defined performance requirements.

There is no need for pre-generation and storage of parity check matrices. It is only necessary to provide initial parameters, as shown in Fig. 1. The circuit operation is based on group ring mathematics and thus is suitable for a wide range of implementation architectures including serial, pipelined serial, vector serial and partially parallel. Of these architectures, the technology has particular benefits on the vector serial and the partially parallel implementations.

There are five main steps in a process to generate a parity check matrix which can be used for encoding and decoding of data:

- Selection of an RG Matrix Structure -- choosing a suitable structure which can deliver the performance desired.
- Selection of Group Ring Elements - choosing a suitable Ring (such as Galois Field 2 (binary numbers)) and choosing suitable Group elements chosen according to a scheme.
- Sub Matrix Generation_- generating the sub matrices for the RG matrix through some suitable row filling scheme. Such a row-filling scheme is preferably linear and cyclic.
- RG Matrix Generation_- generating the RG matrix by a cyclic arrangement of the sub matrices
- Parity-Check Matrix Generation - generating the parity-check matrix by deleting suitably chosen columns from the RG matrix to achieve the desired performance and then transposing the matrix.

When the parity-check matrix H (transformed to a corresponding generator/encoding matrix) is used to encode data it is desirable that the encoded data (consisting of message bits and parity check bits) can withstand errors during transmission or storage. The level of such errors is usually expressed as a bit error rate (BER) at a given signal to noise ratio. The better the encoding matrix the better the BER for a given signal to noise ratio and the lower signal to noise ratio that can be used to achieve the same BER. For most applications a minimum BER is required, for example $10^{-6}$ for wireless telecom applications.

LDPC code, as every linear block code, can be represented by a Tanner graph showing mutual relations between so called 'bit nodes' (corresponding to the LDPC matrix columns) and 'check nodes' (corresponding to the LDPC matrix rows).

To achieve a low BER it is desirable that there be good 'cross-linking' between parity-check bits and data (e.g. message) bits so that errors can be corrected. This means that each parity check node should be connected to multiple bit nodes, allowing for errors to be corrected due to multiple parity bits containing information on the error affected data bit. Likewise errors in the parity bits can be corrected through the links to multiple data bits. Short loops, for example "4-cycle", occur when check nodes and bit nodes are only linked together in small cycles thus increasing the likelihood of being unable to correct for errors. Such short loops linking closely spaced parity check and bit nodes on the Tanner graph should be minimised, and this has been achieved by our mechanism for selection of group ring elements. In fact, careful selection of group ring elements in the invention can completely avoid 4-cycle loops (loops linking only 2 check nodes and 2 bit nodes together). Furthermore, appropriate column deletion can minimise or remove 6 and 8-cycle loops, by removing combinations of columns containing these loops.

The ability of a code to correct from a large number of errors is often measured as the distance of the code. The distance is a measure of the minimum number of positions (bits) for which two codewords differ. The more positions across which two codewords differ, the more likely that any errors will still leave a message that can only be corrected to a single codeword. If too many errors occur or a low distance exists then it may be impossible to correct for the errors.

Irregular matrices with no patterns and distributed column and row weights (the number of non-zero elements in any given column or row of the parity matrix) are likely to have higher distances. Such irregular matrices could be generated using more complex filling patterns for the sub-matrices.

This process needs to be carefully coupled with the column deletion and group ring element selection processes to ensure that the resultant parity check matrices do not contain any zero weight columns or rows and to ensure that the RG matrix is invertible. There can furthermore be a different row filling pattern for each sub-matrix.

Parity-check matrices created using the present invention are fully deterministic and can be quickly generated line-by-line on the basis of very few initial parameters. Furthermore, when used in so-called 'staircase structure' they can readily be used for fast and simple encoding of data in linear time. The algebraic character of the matrices combined with the 'staircase' results in fast coding and decoding speed coupled with flexible coding rate selection and considerable reduction of the indexing memory needed to hold random parity check matrices. These improvements are achieved while maintaining decoding performance close that achieved by using random parity check matrices. Such matrices might prove particularly useful for portable battery-operated wireless devices, or other devices where fine selection of coding rate and operation close to the Shannon Limit is desirable with low complexity error correction.

<u>Example</u>

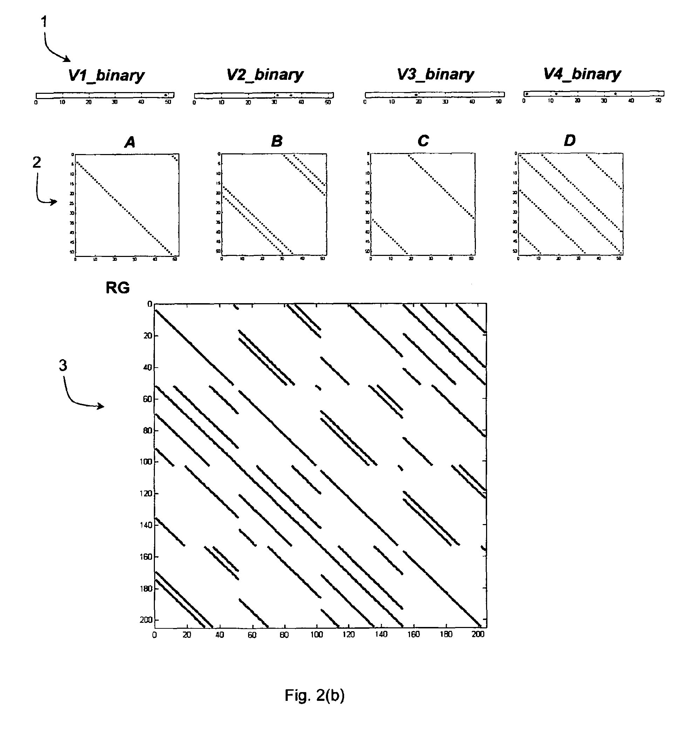

Referring to Figs. 1 and 2, an RG Matrix Structure of size 4 is chosen, with a code size of 204. Group ring elements are then chosen represented by four vectors: *V1, V2, V3,* and *V4*.

RG matrix size: N = 4
Code (codeword) size: $n_c$ = 204; Sub matrix size: n = $n_c$/N = 204/4=51;
V1=[3] V2=[16,21] V3=[33] V4=[0,18,40].

The $V_1$ to $V_N$ vectors are then transformed through the following set of actions:

a) replace *0* with *n* in each vector *(if V(i)=0 → V(i)=n)*
b) subtract each vector from *n (V=n-V;)*

Calculated as:

n=51;
V1 = 51-V1 = 51-[3] = [48];
V2 = 51-[16,21] = [35,30];
V3 = 51-V3 = 51-[33] = [18];
V4 = 51-V4 = 51-[51,18,40]=[0,33,11];
// in V4, 0 has been replaced with 51 (before subtraction)

If indexing starts from 1 (e.g. as in MATLAB), a value of 1 should be added to each of the elements. In such case: V1 = [49], V2 = [36,31], V3 = [19], V4 = [1,34,12]
The above actions are to make the generation process consistent with the notation used in group-ring theory.
Next, referring specifically to Fig. 1, the vectors are transformed to a binary form, where each element in $V_1$ to $V_N$ defines position of '1' in a row vector of n elements in *V1_binary, V2_binary* ..., respectively, through the following actions:

a) initiate all vectors as rows containing n zeros *(V_binary=zeros(1,n);)*
b) input 1s in places defined by elements in $V_1$ to $V_N$ *(V_binary(V(i))=1;)*

Referring, specifically to Fig. 2, the four vectors *V1 - V4* (given general reference numeral 1) are used to generate N square cyclic sub-matrices 2: **A, B, C** and **D**, by a cyclic shift of the relevant vector.
The system then creates an RG matrix 3 by a cyclic arrangement of the above sub-matrices, e.g.

$$RG = \begin{pmatrix} A & B & C & D \\ D & A & B & C \\ C & D & A & B \\ B & C & D & A \end{pmatrix}$$

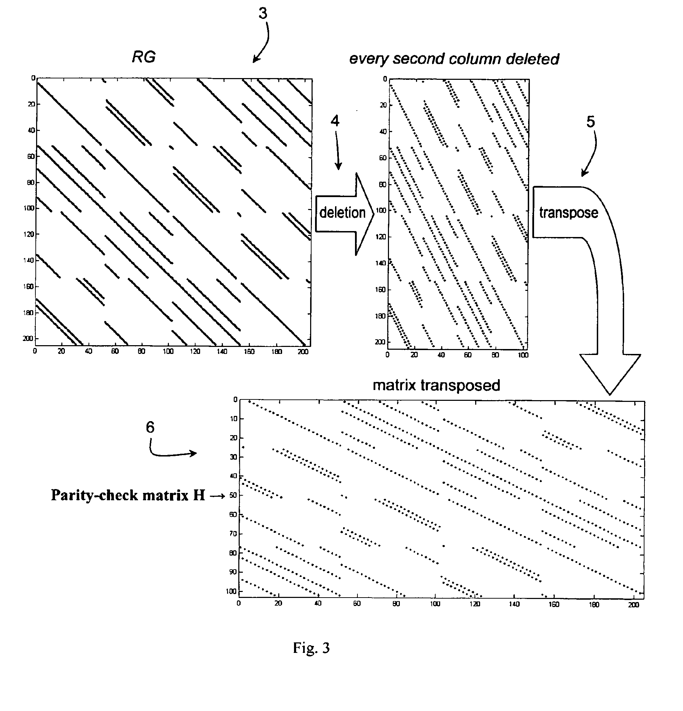

Referring, specifically to Fig. 3, the system then generates a parity-check matrix H, 6, on the basis of the RG matrix 3 with column deletion 4 and transposing 5, through the following actions:

a) check if matrix RG is invertible

\- if not, choose another combination of the initial vectors

b) delete (choose) appropriate columns from RG to achieve the desired code rate
c) transpose the matrix

The size of the parity-check matrix is ($n_c$-k)-by-$n_c$, where $n_c$ - codeword size, k - message size (rate=k/$n_c$).
For rate = ½, k = $n_c$/2, so half of the columns from RG must be deleted
Here, we delete every second column (starting from the first one), and next we transpose the matrix.

In summary, the system:

1) Starts with the selection of the RG matrix structure and the Group Ring elements
2) Creates corresponding binary vectors
3) Generates square sub-matrices from those vectors
4) Creates matrix RG by an appropriate arrangement of the sub-matrices
5) Deletes columns from RG
6) Transposes the matrix

Following the example above, the following describes the invention in more general terms.

The simplest structure of the RG matrix is 2x2 composed of 2 different square matrices **A** and **B** in the following way:

$$\begin{pmatrix} A & B \\ B & A \end{pmatrix}$$

Size of the RG matrix (row or column length) is equal to the codeword length $n_c$. Therefore, in case of a 2x2 RG matrix structure the sub-matrices A and B will have a size of $n_c/2$.

For the process of pseudo-random initial vector generation it is often beneficial to use a 4x4 structure or larger in order to spread the bits more uniformly over the whole RG matrix. In principle, for binary codes the number of sub-matrices in a row (column) of the RG matrix is an integer power of 2. Therefore, the following structures are possible: 2x2, 4x4, 8x8, 16x16, etc. In each case the sub-matrices would be arranged in a cyclic manner. In general, the method can be used with codes over higher Galois Fields. Different numbers of sub-matrices and different arrangements of the sub-matrices in the RG matrix are also possible. From the perspective of hardware parallelism in the decoder, it is more important that a 2 x 2 matrix can be expanded to an L x L matrix, where L»2, than it is to reduce an L x L matrix down to a 2x2 matrix.

The following examples show the structures of 4x4 and 8x8 RG matrices:

4x4 - 4 square sub-matrices, each of $n_c/4$ size;    8x8 - 8 square sub-matrices, each of $n_c/8$ size;

$$\begin{pmatrix} A & B & C & D \\ D & A & B & C \\ C & D & A & B \\ B & C & D & A \end{pmatrix} \qquad \begin{pmatrix} A & B & C & D & E & F & G & H \\ H & A & B & C & D & E & F & G \\ G & H & A & B & C & D & E & F \\ F & G & H & A & B & C & D & E \\ E & F & G & H & A & B & C & D \\ D & E & F & G & H & A & B & C \\ C & D & E & F & G & H & A & B \\ B & C & D & E & F & G & H & A \end{pmatrix}$$

In principle, any RG matrix structure can usually be reduced to a 2x2 structure, without loss of performance. For example, a code described by the following vectors in a 4x4 structure of size 96:

V1=(9, 15, 19)    V2=(3, 20)    V3=(22)    V4=(12)    **(RG4x4)**

can be reduced to a 2x2 structure represented by 2 vectors:

V1=(3, 20, 33, 39, 43)    V2=(12, 46)    **(RG2x2)**

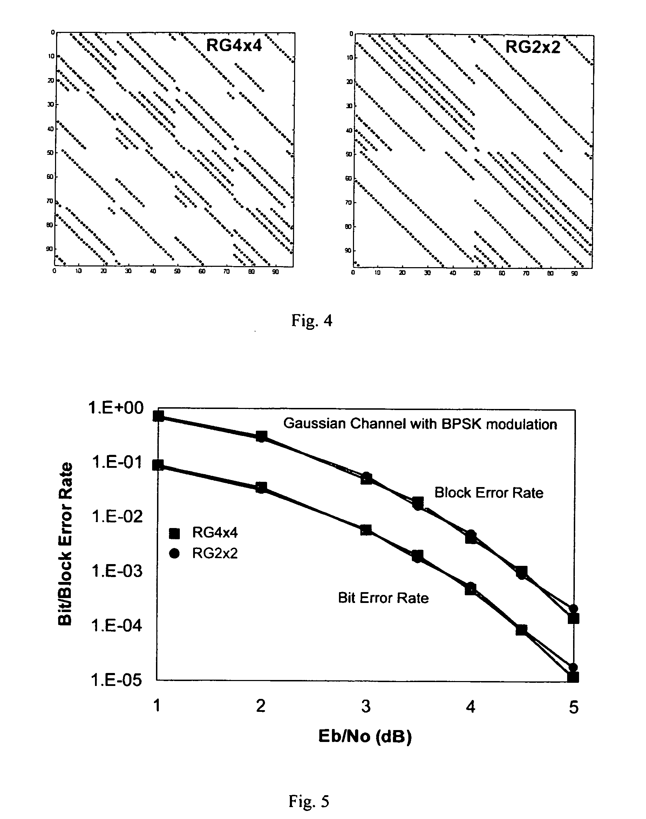

First rows of RG4x4 and RG2x2 are identical - the difference between the matrices lies in the method of filling the following rows, as shown in Fig. 4. Fig. 5 shows performance comparison (Gaussian Channel, BPSK modulation) for codes of size=96 and rate=1/2 created on the basis of the RG4x4 and RG2x2 matrices.

In case of binary codes (Galois Field 2) the initial vectors define positions of bits having a value of '1' in a first row of each sub-matrix included in the RG matrix. Then, the following rows of each of the sub-matrices are created by a cyclic shift (sequential one bit shift to the right or to the left) or alternative operation of the initial row. Similar principle would also apply to codes within higher Galois Fields.

The selection of the Group Ring elements constituting the vectors is performed in a pseudo-random way with the following constraints:

- elements are chosen within the range of indexes of a given sub-matrix from 0 to n-1 inclusive, where n is defined as the code size divided by N
- differences (spacings) and cyclic differences (n minus spacings) between elements in each block (sub-matrix) are never repeated
- differences and cyclic differences between elements in one block are never repeated in another block
- differences and cyclic differences between elements in one vector and the subsequent vector are never repeated
- total number of elements should be kept low in order to make the parity-check matrix sparse (low density)

Avoiding repetitions in differences between the elements is directly related to avoiding 4-cycles in the corresponding codes. The following example shows how this can affect the code performance.

Let's consider the same code as described earlier, represented by vectors:

$$V1=(9, 15, 19) \quad V2=(3, 20) \quad V3=(22) \quad V4=(12) \quad \textbf{(code1)}$$

Code1 has been designed accordingly to the constraints listed above.

In contrast, a very similar code (constructed by changing 1 element in V1 and 1 element in V2):

$$V1=(9, 15, 21) \quad V2=(14, 20) \quad V3=(22) \quad V4=(12) \quad \textbf{(code2)}$$

contains repetitions of differences between elements, namely:

15-9=6 (in V1) and 21-15=6 (in V1) and 20-14=6 (in V2)

These repetitions result in significant performance deterioration.

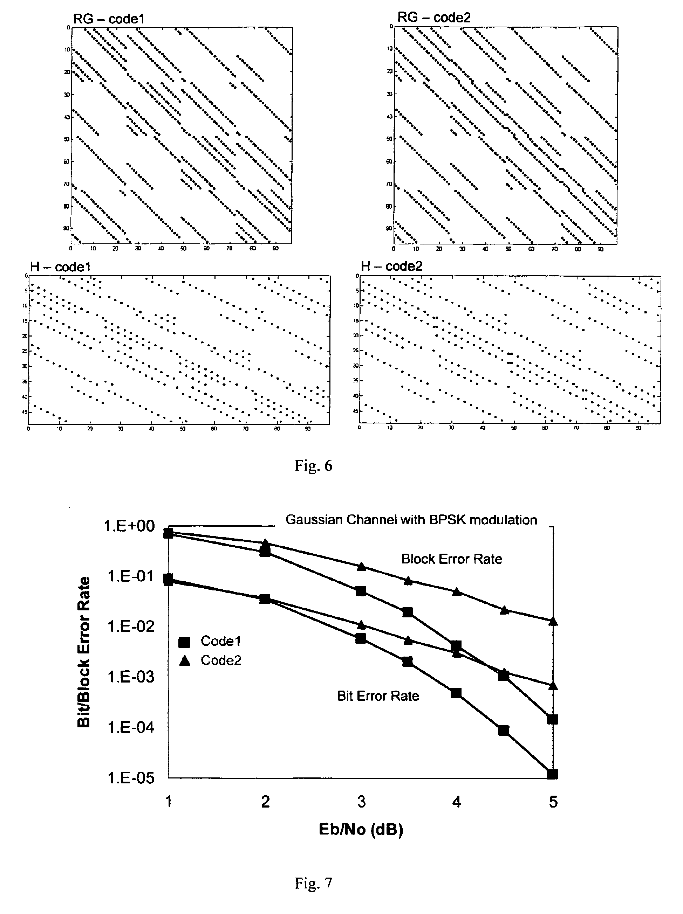

Fig. 6 shows the structure of RG matrices representing those codes together with the corresponding parity-check matrices H (H - created by deleting every second column from RG - for code rate = 1/2, and subsequent matrix transpose) and Fig. 7 - their performance over a Gaussian Channel with BPSK modulation.

Parity-check matrix H is created from the RG matrix by deletion (choice) of a number of columns from RG and subsequent matrix transpose. The code rate is defined by the shape of the parity-check matrix which is determined by the number of columns deleted (chosen) from RG. In general, the H matrix has a size of $(n_c-k)$-by-$n_c$, where $n_c$ is the codeword length (corresponding to the size of RG) and k is the message (data block) length. Therefore the number of columns to be deleted from RG in order to get H is equal to the number of the message bits. The code rate is defined as $k/n_c$. Thus, for a code rate of ½, half of the columns from RG must to be deleted; similarly, for a code size of 1/3 one third of columns must be deleted, etc. In each case such matrix must be transposed after the deletion is completed.

The choice of which columns should be deleted from RG in order to create the parity-check matrix is normally defined by a pattern. For example, in case of a code having a rate of ½, half of the columns must be deleted. Here, the simplest and most obvious pattern is to delete every second column. This creates a matrix H that has a uniform row weight distribution and 2 alternating values of column weights. By choosing a different pattern we can introduce more variety in the column weight distribution and improve the code performance. Performance will in general be enhanced by deletion patterns which generate column weight distributions containing no weights of zero or one, and few if any occurrences of weight 2. The weight distribution also needs to take into account any other structure being applied in encoding, such as a staircase pattern. A distribution pattern also needs to contain some height weight values to maximise the distance of the code. A good distribution pattern contains a heavy distribution around the lower values with a few high weight numbers. The maximum column weights will also effect the hardware implementation, resulting in a balance between performance and implementation.

Here, as in the case of the initial vector choice, the deletion pattern can also be related to avoiding short cycles in the LDPC code. Assuming that all 4-cycles have been eliminated in the vector choice process, the code can be further optimized by removing 6-cycles, 8-cycles, etc., through a suitable choice of the column deletion pattern. An alternative approach is to logically analyse the RG matrix calculating the location of short cycles, deleting those columns and repeating until the desired rate is achieved, and convert the columns deleted into a pattern. Care must be taken to ensure that deletion of columns does not lead to a breaking of the rules by which vectors were initially chosen. In general, both the initial vector choice and the column deletion pattern choice should be optimized in parallel. A pattern that has a positive impact on one code performance may cause performance deterioration in another code. Patterns resulting in column weights equal to 0 must be avoided, as they do not form a valid code.

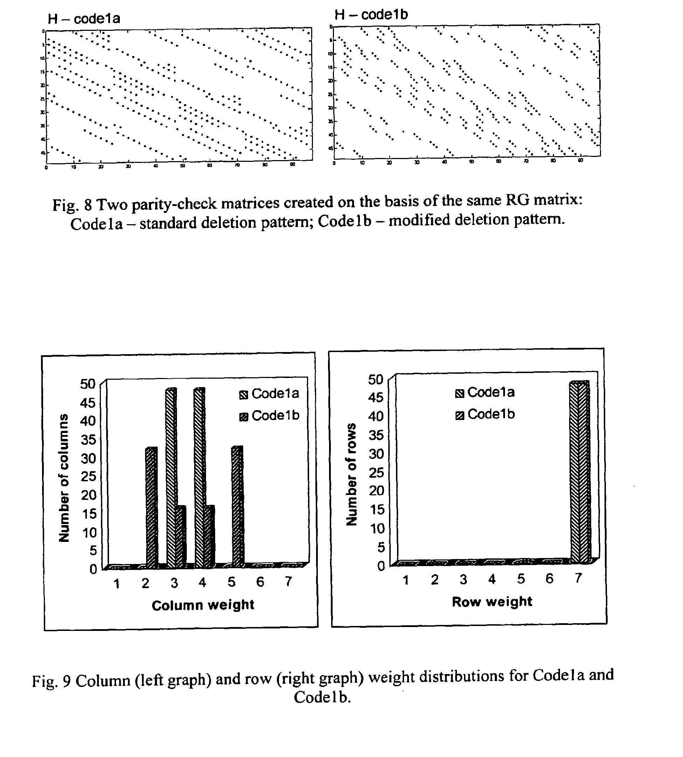

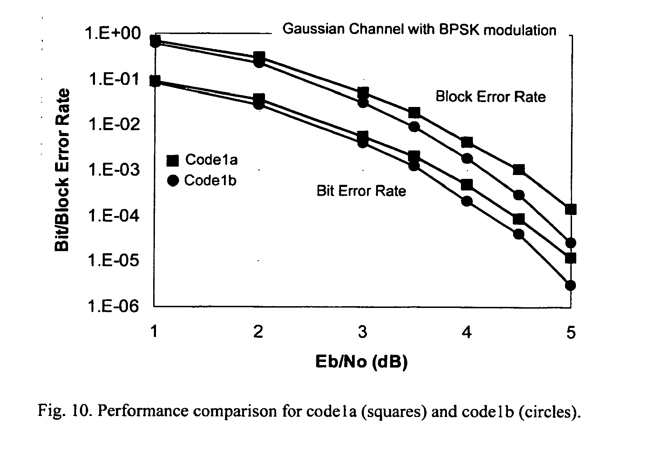

Fig. 8 shows structures of two parity-check matrices created on the basis of code1 described above. Code1a is identical to code 1 depicted in Fig. 6 and was created in a standard way - by deleting every second column from RG, starting from the first one (sequence of deleted columns: 1,3,5,7,9,11,13,15,17,...,95). In contrast; code1b was created using a different column deletion pattern: first three adjacent columns remain in RG and next three adjacent columns are deleted (e.g.: 4,5,6,10,11,12,16,17,18,...,96). In both cases the matrices were transposed after the deletion. Fig. 9 compares column and row weight distributions calculated for these matrices. It is clear that code1b has more diverse column weight distribution and exhibits better performance over a Gaussian Channel (Fig. 10). Row weight is constant for both code 1a and code1b which is a direct consequence of the parity-check matrix generation method. One way to diversify the row weight distribution is by changing the row filling pattern in RG, as described below.

Changing the row-filling pattern in RG may further improve the code performance by making the matrices more irregular. The standard cyclic row-filling always creates matrices with regular row weight, while the column weight may vary depending on the column deletion pattern. In order to introduce irregularity also to the row weight distribution, the row-filling pattern must differ from a standard cyclic pattern.

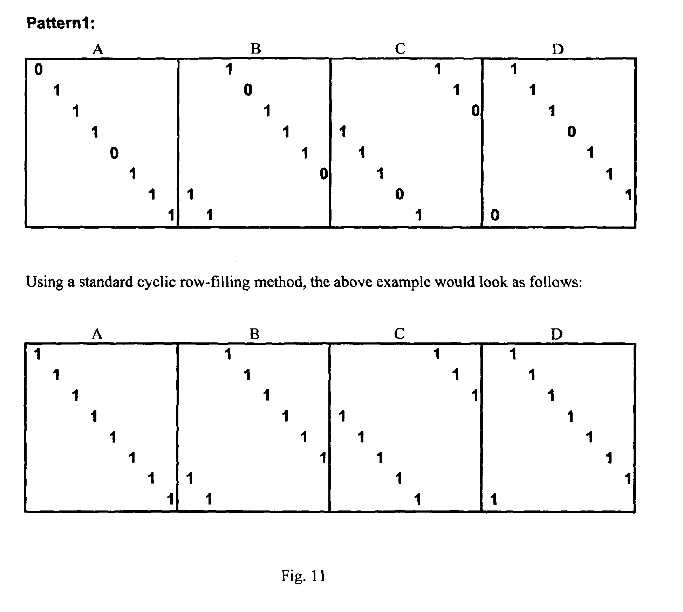

For example, cyclic patterns using increments greater than one are possible, and can generate good row distribution patterns. Other such non-standard row-filling in a 4x4 RG matrix may be achieved by inputting '0' instead of '1' in every 4th row, starting from the 1st row in sub-matrix **A,** from the 2nd row in sub-matrix **B**, the 3rd one in **C** and 4th in **D**, as shown in Fig. 11.

Many different row-filling patterns are possible. In general, we should avoid patterns resulting in column weights or row weights equal to 0, unless such rows are deleted in the subsequent column deletion phase, as well as other patterns creating non-invertible RG matrices. Row filling patterns should be optimized in parallel with the initial vector choice and the column deletion pattern. For instance code1, described earlier, does not form a valid code when using pattern1 because it results in a non-invertible RG matrix. Thus, in order to create a valid code we must choose a set of different vectors, for example:

**Code3; using Pattern1:**

$$V1=(19) \quad V2=(10, 15) \quad V3=(3, 5, 12, 13) \quad V4=(4, 8)$$

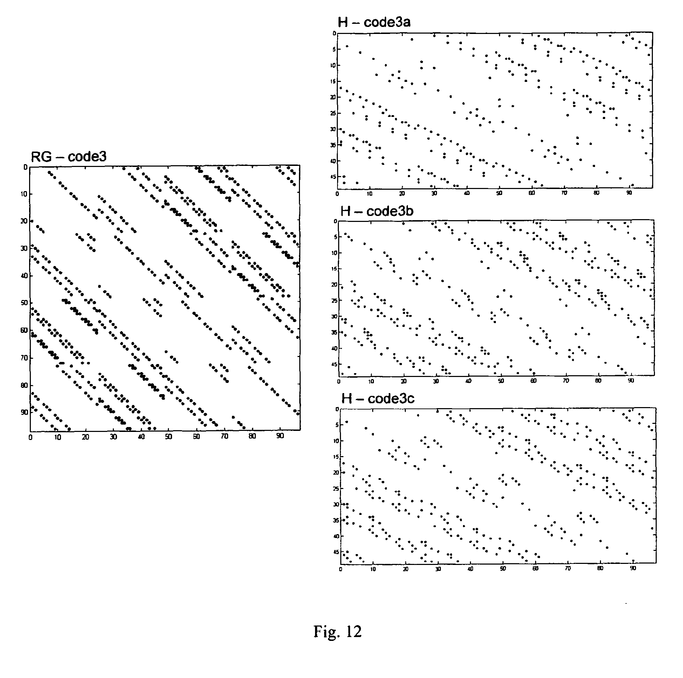

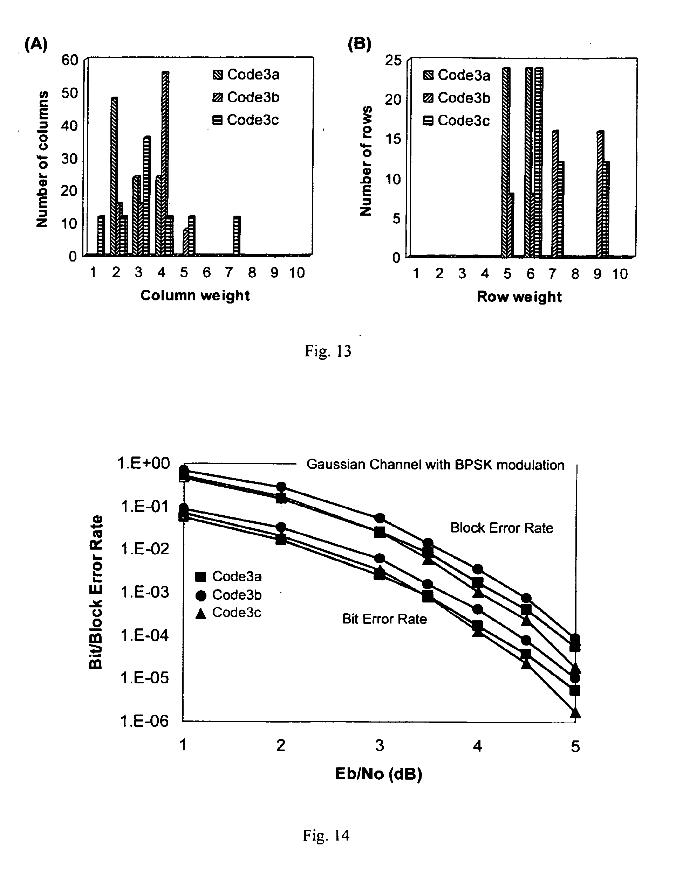

The RG matrix formed on the basis of code3 and pattern1 is shown in Fig. 12 together with corresponding parity-check matrices representing three codes of rate=1/2. Code3a was formed by deleting every second column from RG (as in code1a described earlier), code3b was created using a column deletion pattern equivalent to the one used previously for code1b (first three adjacent columns remain in RG, next three adjacent columns are deleted, etc.) while code3c was created by deleting the following columns: 1, 3, 4, 8, etc... (repeated every 8 columns). Fig. 13 shows column and row weight distributions calculated for code3a, code3b and code3c. It is clear that pattern1 results in irregular column and row weight distribution, even in case of a standard column deletion pattern (code3a). As expected, combining non-standard row-filling pattern with non-standard column deletion pattern introduces more diversity in the weight distributions (code3b and code3c). Here, however, although the performance of code 3c is better than the performance of code3a, code3b (having the column deletion pattern identical to the one used previously for code1b) performs worse than code3a. This is in contrast with the case described previously for code1a and code1b and further proves that in order to minimize bit error rates all the parameters (initial vectors, column deletion pattern and row-filling pattern) should be optimized simultaneously. In this case code3c has been optimized for the best performance as shown in Fig. 14.

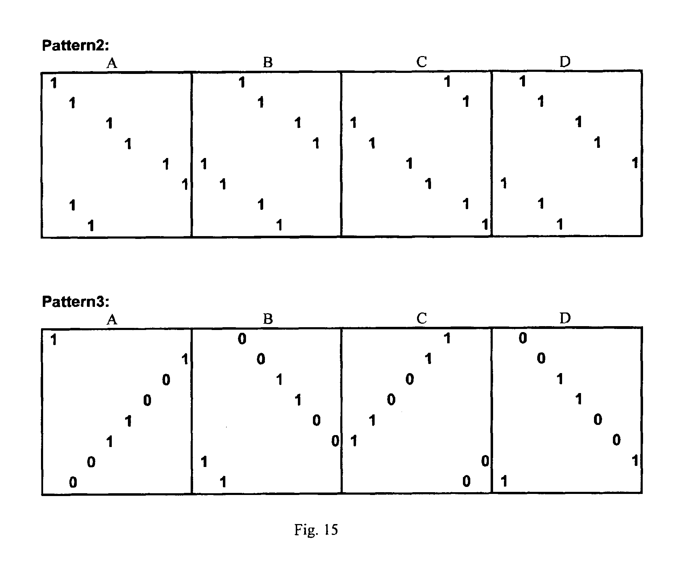

In practice, there is a wide variety of different row-filling patterns that can be used to populate the RG matrix, with some alternative examples shown in Fig 15. The patterns can be the same or different in each of the sub-matrices - the principal constraints are: RG matrix must be invertible in GF(2) and parity-check matrix H should have no columns or rows having a weight of 0. While there is flexibility in terms of row-filling patterns, this is contingent on ensuring that the parity check matrix post column deletion does not break the rules on choice of suitable initial vectors and the rules on column weight distribution.

Mathematical Basis

The following describes the mathematical basis for the benefits of the invention.

Avoiding short cycles

This section gives a method on how to avoid short cycles in the graph of the check matrix. A mathematical proof is given.

Specifically, necessary and sufficient conditions are given on the group ring element $u$ in terms of the group elements that occur in its expression so that its corresponding matrix U has no short cycles in its graph. These conditions also determine when and where short cycles can occur in a group ring matrix $U$ constructed from $u$ and it is possible to avoid these short cycles when constructing codes from $U$.

It should be noted that the unit-derived method for constructing codes has complete freedom as to which module W in a group ring RG to choose. This section determines where short cycles can occur in general and thus the module W can be chosen so as to avoid these short cycles. Choice of the module W determines the generator and check matrices.

In general:

Let $RG$ denote the group ring of the group $G$ over the ring $R$. Suppose $u \in RG$ is to generate or check a code. Let $G$ be listed by $G=\{g_1,g_2,...,g_n\}$.

$$\text{Let } u = \sum_{i=1}^{n} \alpha_i g_i \text{ in } RG.$$

For each (distinct) pair $g_i$, $g_j$ occurring in $u$ with non-zero coefficients, form the (group) *differences* $g_i g_j^{-1}$, $g_j g_i^{-1}$. Then *the difference set* of $u$, $DS(u)$, consists of all such differences. Thus:

$$DS(u) = \{g_i g_j^{-1},\ g_j g_i^{-1} \mid i \neq j,\ \alpha_i \neq 0,\ \alpha_i \neq 0\}.$$

Note that the difference set of $u$ consists of group elements.

<u>Theorem 1.1</u> *The matrix U has no short cycles in its graph if and only if the DS(u) has no repeated (group) elements*.

        Proof:    The rows of $U$ correspond in order to $ug_i$, $i = 1,..., n$,
Then $U$ has a 4-cycle
$\Leftrightarrow$
for some $i \neq j$ and some $k \neq l$, the coefficients of $g_m$, $g_l$, in $ug_i$ and $ug_j$ are nonzero.
$\Leftrightarrow$
$ug_i = ... + \alpha g_\kappa + \beta g_\lambda + ...$
and
$ug_j = ... + \alpha_j g_\kappa + \beta_j g_\lambda + ...$
$\Leftrightarrow$
$u = ... + \alpha g_\kappa g_\iota^{-1} + \beta g_\lambda g_\iota^{-1} + ...$
and
$u = ... + \alpha_j g_\kappa g_\varphi^{-1} + \beta_j g_\lambda g_\varphi^{-1} + ....$
$\Leftrightarrow$

$DS(u)$ contains both $g_k g_i^{-1} g_j g_i^{-1} = g_k g_i^{-1}$ and $g_k g_j^{-1} g_i^{-1} = g_k g_i^{-1}$. This happens if and only if $DS(u)$ has a repeated element.

Repeated Elements:

Suppose now $u$ is such that $CD(u)$ has repeated elements.

Hence $u=...+\alpha_m g_m+\alpha_r g_r+\alpha_p g_p+\alpha_q g_q+...$, where the displayed $\alpha_i$ are not zero, so that $g_m g_r^{-1}=g_p g_q^{-1}$. The elements causing a short cycle are displayed and note that the elements $g_m$, $g_r$, $g_p$, $g_q$ are not necessarily in the order of the listing of $G$.

Since we are interested in the graph of the element and thus in the non-zero coefficients, replace a non-zero coefficient by the coefficient 1. Thus write $u=...+g_m+g_r+g_p+g_q+...$ so that $g_m g_r^{-1}=g_p g_q^{-1}$.

Include the case where one $p$, $q$ could be one of $m$, $r$ in which case it should not be listed in the expression for $u$

Then

$ug_m^{-1}g_p=...+g_p+g_r g_m^{-1}g_p+...=...+g_p+g_q+...$ and $ug_p^{-1}g_m=...+g_m+g_q g_p^{-1}\ g_m=...+g_m+g_r+...$ (Note that $ug_m^{-1}g_p=ug_r^{-1}g_q$ and $ug_p^{-1}g_m=ug_q^{-1}g_r$)

Thus to avoid short cycles, do not use the rows determined by $g_m^{-1}g_p$ or $g_p^{-1}g_m$ row in $U$ if using the first row, or in general, if $g_i$ row occurs then $g_i g_m^{-1}g_p$, and $g_i g_p^{-1}g_m$ rows must not occur.

Similarly when $CD(u)$ has repeated elements, by avoiding certain columns in $U$, it is possible to finish up with a matrix without short cycles.

Special cases:

Let $S = \{i_1, i_2, ..., i_r\}$ be a set of non-negative unequal integers and n an integer with $n > i_j$ for all $j$ = 1, 2, ..., $r$.

Then the *cyclic difference set* of $S$ mod $n$ is defined by $DS(n) = \{i_j - i_k \bmod n|1 \leq j, k \leq r, j \neq k\}$. This is a set with possibly repeated elements.

For example if S = {1, 3, 7} and n = 12 then $DS(12)$ = {2, 6, 4, 10, 6, 8}.

$$\text{If } |S| = r \text{ then } |DS(n)| = r(r-1).$$

Consider the group ring $RC_n$ where $C_n$ is generated by g. Suppose $u = \alpha_{i_1}g^{i_1}+\alpha_{i_2}g^i_2+..+\alpha_{i_r}g^{i_r} \in RC_n$ with $\alpha_{ij} \neq 0$. Set S = $\{i_1, i_2,..., i_r\}$ and define the cyclic difference set mod $n$ of $u$, $CD(u)$ by saying $CD(u) = DS(n)$

Notice that this difference set is the set of exponents (when the exponents are written in non-negative form) of the group ring elements in the difference set defined under the 'in general' section above.

Let U be the RG-matrix of $u$; $U$ depends on the listing of the elements of $C_n$ and we choose the natural listing.

Theorem 1.2 *U has no 4-cycles in its graph if and only if CD(u) has no repeated elements*.

Proof: The proof of this follows from Theorem 1.1.

Let $G = C_n \times C_m$ be the direct product of cyclic groups $C_n$, $C_m$ generated by g, $h$ respectively.

We list the elements of $G$ by 1, $g$, $g^2$,..., $g^{n-1}$, $h$, $hg$, $hg^2$,..., $hg^{n-1}$, ..., $h^{m-1}$, $h^{m-1}g$, ..., $h^{m-1}g^{n-1}$.

We write out and element of $RG$ using this listing and thus suppose $u = a_0 +h(a_1)+.. .+h^{m-1}a_{m-1}$ is in $RG$ where each $a_i \in C_n$.

Set $S$ to be the set consisting of all the exponents occurring in $a_0, a_1,..., a_{m-1}$ and define $CD(u) = DS(n)$.

Then Theorem 1.1 can be used to prove the following:

Theorem 1.3 *U has no 4-cycles if and only if CD(u) has no repeated elements*.

Repeated elements (in special cases):

We may have a system where $CD(u)$ has repeated elements.

Suppose $u = ... + g^m + g^r + g^p + g^q + ...$ so that $m - r = p - q \bmod n$. Assume with loss of generality that $p > m$.

Include the case where one $p$, $q$ could be one of $m$, $n$ in which case it should not be listed in the expression for $u$

Then with $p > m$, $ug^{p-m} = .. + g^p + g^{r+p-m}. + ... = ... + g^p + g^q + ..$ and for $n > n + m - p > 0$, $u^{n+m-p} = .... + g^m + g^{q+m-p} = g^m + g^r$.

(Note that $m-p = r-q \bmod n$ so that $ug^{p-m} = ug^{q-r} = ug^{n+q-r}$ and $ug^{n+m-p} = ug^{n+r-q} = ug^{r-q}$.)

Thus to avoid short cycles, do not use the $p -m$ row or the $n +m- p$ row in $U$ if using the first row or, in general, if $i$ row occurs then $i + p - m$, or $i + n + p - m$, rows must not occur.

Improving the distance:

Consider then two elements $u$, $v \in Z_2 C_n$ such that $uv = 0$ and rank $u$+rank $v = n$. Let $U$, V respectively be the corresponding $n \times n$ matrices corresponding to $u, v$.

Thus the code is $C = \{\alpha u|\alpha \in Z_2 C_n\}$ and $y \in C$ if and only if $yv = 0$.

Suppose now $y = \Sigma\alpha_i g^i$ is a general element in $C$. We are interested in how short $y$ can be. More precisely supp($y$) is the number of non-zero $\alpha_i \in y$. Thus distance of $C = \min_{y \in C}$ supp($y$).

Take $v$ in the form $\sum_{j=1}^{r} g^{-i_j}$; we are working over $Z_2$ so each coefficient is either 0 or 1.

Then $y \in C$ if and only if $yv = 0$. Thus by considering the coefficients of $g^k$, $k = 0, 1, ..., n - 1$ in $yv$ we see that $y \in C$ if and only if the following equations hold:

$$
\begin{array}{cccccc}
\alpha_{i_1} & + \alpha_{i_2} & +... & + \alpha_{i_\rho} & = & 0 \\
\alpha_{i_1+1} & + \alpha_{i_2+1} & +... & + \alpha_{i_\rho+1} & = & 0 \\
. & . & . & . & . & . \\
. & . & . & . & . & . \\
. & . & . & . & . & . \\
\alpha_{i_1+v-1} & + \alpha_{i_2+v-1} & +... & + \alpha_{i_\rho+v-1} & = & 0
\end{array}
$$

where suffices are interpreted mod $n$. We are interested in the non-zero-solutions of this. The matrix obtained as expected is a circulant matrix. We will simply write it as:

$$
\begin{array}{cccccc}
i_1 & +i_2 & +... & +i_r & = & 0 \\
i_1 + 1 & +(i_2 + 1) & +... & +(i_r + 1) & = & 0 \\
. & . & . & . & . & . \\
. & . & . & . & . & . \\
. & . & . & . & . & . \\
(i_1 + n - 1) & +(i_2 + n - 1) & +... & +(i_r + n - 1) & = & 0
\end{array}
$$

Note that every non-zero element occurs the same number of times in this array/matrix.

If there are $s$ non-zeros in the first column then there are s non-zeros in all columns.

In considering the shortest distance we may assume that the coefficient $\alpha_0$ is not zero in a shortest non-zero word.

Suppose now we have a unit-derived code C = $Wu$ where $uv = 1$ in the group ring $RG$. Let $G = g_1, g_2, ..., g_n$ and suppose that $W$ is generated as a module by $S = \{g_{i_1}, g_{i_2}, .., g_{i_r}\}$. Then $y \in C$ if and only if the coefficient of each $g_k$ with $g_k \notin S$ in $yv$ are all zero.

We then write $y$ in the general form $\alpha_1 g_1 + \alpha_2 g_2 + ... + \alpha_n g_n$ and consider $yv$. From the fact that the coefficients of each element in $G$ not in $S$ in $yv$ are all zero, we get a system of $r$ homogeneous equations in the variables $\alpha_i$.

Thus corresponding to each element in $G - S$ we get an equation.

Each homogeneous equation is derived from considering the coefficient of each $g_{i_k} \in S$ in $yv$.

The distance of the code is the shortest nonzero solution of this system of equations.

Suppose then the shortest distance is s and occurs when $\{al_{i_1}, \alpha_{i_2}, ..., \alpha_{i_3}\}$ are nonzero and all the other $\alpha_j$ are zero.

These nonzero coefficients occur in the system of equations.

Look at the equations where these nonzero solutions occur and by careful choice delete some $g_k$ from S. We get a new system of equations with one extra equation. This new system includes the old system so any solution of this is a solution of the new system is a solution of the old one so that the distance of the new one is at least as big as the distance of the old one.

We can then reconsider the old equations and see where the $\{al_{i_1}, \alpha_{i_2}, ..., \alpha_{i_3}\}$ occur. Any equation where none of these occur can be eliminated and this results in adding an extra element to $S$.

In-line (row-by-row) LDPC Matrix Generation

One of the key advantages of an algebraic approach to LDPC matrix generation is its ability to generate the LDPC matrix on demand or even a specific row or column on demand. In conventional encoding operations the encoding matrix is multiplied by the correct sized block of information to be encoded, and the resulting data transmitted or stored. Such matrix operations can be implemented line by line thus greatly reducing the quantity of memory or data registers needed. The invention can be applied to such a line by line implementation, as described below.

In the encoding process the generator/encoding matrix (of size $n_c \times k$, where $n_c$ - codeword size, k - data block size) is first obtained from the corresponding LDPC/parity-check matrix (of size $(n_c-k) \times n$) by suitable matrix transformations, such as the Gaussian elimination. Then the generator matrix is multiplied by each of the blocks of data to be encoded resulting in codewords containing the data bits and parity-check bits. In the matrix multiplication process each row of the generator matrix is sequentially multiplied by the data block at a processing cost proportional to $(n_c\text{-}k)^2$. This computational cost can be reduced by using so-called 'staircase structure' (as described in: D.J.C MacKay, "Information theory, inference and learning algorithms", Cambridge University Press 2003). In such case there is no need for the matrix transformations as the LDPC matrix can be used directly for encoding of data at a cost of order $(n_c\text{-}k)$. In both the standard encoding technique and the method using the 'staircase' approach it is advantageous to generate the parity-check (or generator) matrix line-by-line, as it eliminates the need for storing the whole matrix in memory at all times. The 'staircase' approach gives us further advantage of fast (in linear time) encoding and less processing power needed to perform the process. Thus, the following describes a hardware implementation for a line-by-line LDPC matrix generation process suitable for fast, memory-efficient and power-efficient error-correction coding.

The rows of the parity-check matrix H are equivalent to chosen columns from the RG matrix. We therefore need to use the parameters we chose to generate a suitable LDPC matrix to generate the desired columns of the RG matrix and hence the desired rows of the parity check matrix.

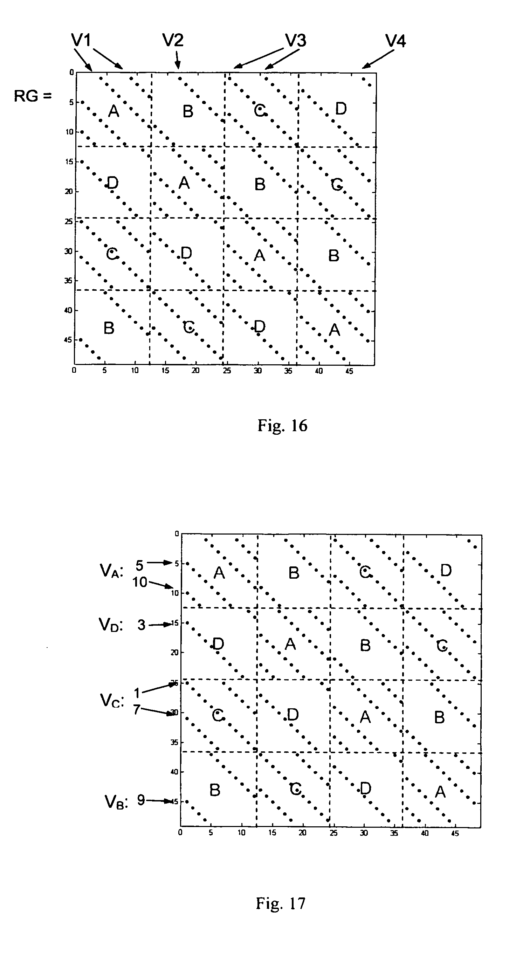

Referring to Figs. 16 and 17, consider a simple example, where the RG matrix of size 48-by-48 is generated using the following parameters;

A 4x4 sub matrix form
Cyclic filling of the rows
No deletion of columns (for simplicity)

$$\text{The vectors: } V1=[4, 9]; \quad V2=[5]; \quad V3=[1, 7]; \quad V4=[11];$$

We can easily find new 4 vectors: $V_A$, $V_B$, $V_C$, $V_D$ defining position of 1s in the columns of RG (equivalent to rows in H).

$$\text{A general formula is:} \quad \text{if } V(i)\sim=1 \quad \text{then} \quad V_x(i)=\text{code\_size}/4\text{-}V(i)+2$$
$$\text{Otherwise} \qquad V_x(i)=1$$

So,

$$\mathbf{V_A} = [48/4\text{-}4+2,\ 48/4\text{-}9+2] = [10,\ 5] = \mathbf{[5,\ 10]};$$

$$\mathbf{V_B} = [48/4\text{-}5+2] = \mathbf{[9]};$$

$$\mathbf{V_C} = [1,\ 48/4\text{-}7+2] = \mathbf{[1,\ 7]};$$

$$\mathbf{V_D} = [48/4\text{-}11+2] = \mathbf{[3]};$$

Now, we can start the inline matrix generation process from the following newly defined vectors:

$$V_A = [5, 10]; \quad V_B = [9]; \quad V_C = [1, 7]; \quad V_D = [3];$$

which define the position of the 1s in the rows of the parity-check matrix H.

First, the vectors are transformed to their binary form, where:

$$V_{A\_binary}=[0\,0\,0\,0\,1\,0\,0\,0\,0\,1\,0\,0] \quad V_{B\_binary}=[0\,0\,0\,0\,0\,0\,0\,0\,1\,0\,0\,0]$$
$$V_{C\_binary}=[1\,0\,0\,0\,0\,0\,1\,0\,0\,0\,0\,0] \quad V_{D\_binary}=[0\,0\,1\,0\,0\,0\,0\,0\,0\,0\,0\,0]$$

The first row of the LDPC parity check matrix (equivalent to the first column in the RG matrix) is therefore given by:

[$V_{A\_binary}$, $V_{D\_binary}$, $V_{C\_binary}$, $V_{B\_binary}$]
[000010000100001000000000100000100000000000001000]

The next row of the parity-check matrix is formed by the defined row shifts of the vectors within each block. In this example with cyclic shifts it will look like this:

[000000100001000010000000001000001000000000000000100]

Then,

[000000010000100001000000000100000100000000000000010]

And so on.

The cyclic shift is continued, until we reach the end of the sub-matrix block. Then we need to change the arrangement of the vectors, depending on the structure chosen. In this case it will be changed to:

[$V_{B\_binary}$, $V_{A\_binary}$, $V_{D\_binary}$, $V_{C\_binary}$]

Each subsequent row is generated on this principle until the entire matrix has been used and then all is repeated.

In all cases some columns from the RG matrix are deleted prior to transposing to generate the desired code rate and performance. We can apply the same equation or method used for selecting which columns to be deleted to the inline implementation. An effective method of achieving this is to add an additional cyclic shift (or whichever row filling approach was used) each time a deleted column is reached, thus creating a row based on the next non-deleted column.

Hardware

By generating a parity check matrix H optimum initial vectors may be chosen for use by a hardware circuit to perform encoding and/or decoding without storing or generating the matrix. The matrix does not need to be generated by the circuit, it could be programmed in at manufacture or initialization, based on a previously generated and tested matrix.

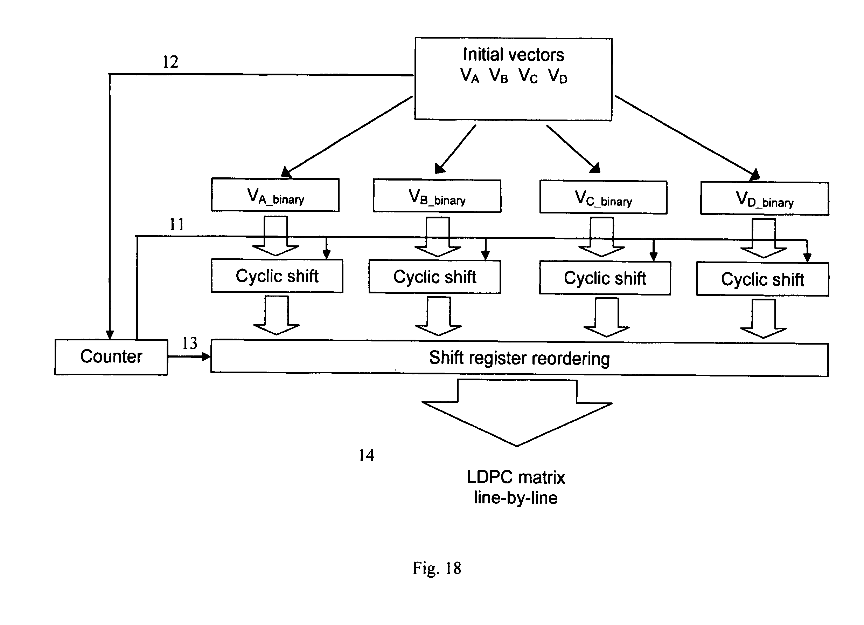

Fig. 18 shows a circuit using 4 shift registers to store the positions of the 1s. The circuit components are:

11, Shift-registers to perform continuous cyclic shift of the binary vectors, controlled by the counter.
12, Information about the code size and rate is input to the counter.
13, The counter controls the block arrangement (on the basis of the code size and the current row number).
14, The output is the current row of the parity-check matrix H.

This implementation is compatible with any of the LDPC generation parameters available.

In another embodiment, a more compact circuit has a single bit counter to track the position of each of the 1s directly. Due to the sparse character of the LDPC matrix this requires significantly less memory and less processing power than using shift registers. It is particularly convenient when the block sizes are integer powers of 2 as the binary counters automatically reset themselves at the end of each cycle.

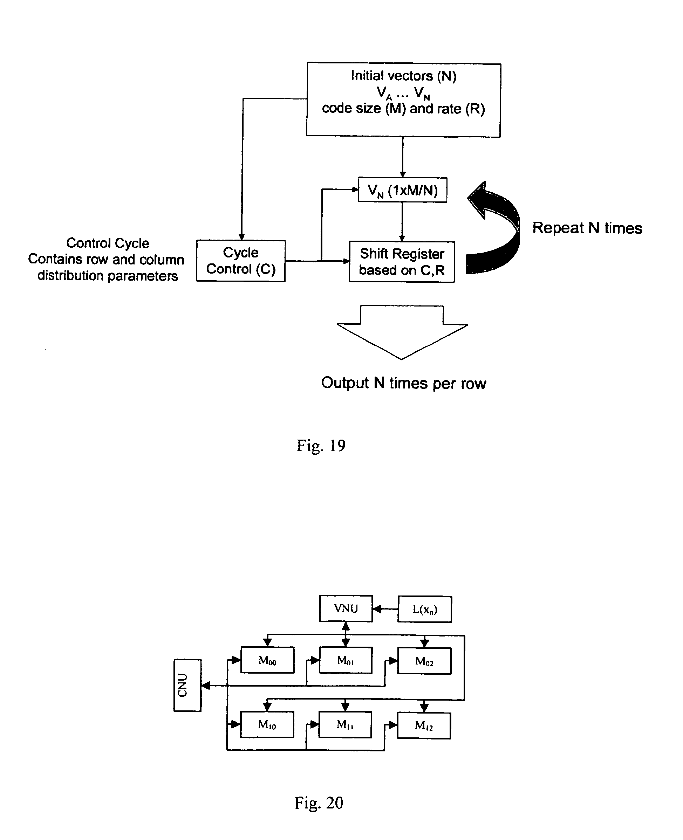

Alternative approaches would be to use a single shift register equal to the sub matrix block length (or counters tracking the 1s in a single block) and cycle the system for each block. This approach would contain an additional register (counter) keeping track of column or row number and would generate the desired row block by block as shown in Fig. 19.

LDPC Hardware Implementation

Memory Organisation

In conventional LDPC encoding and decoding a problem is the required memory addressing complexity for the check node and variable node processing.

It is also known to simultaneously carry out multiple row and column operations within a single clock cycle.

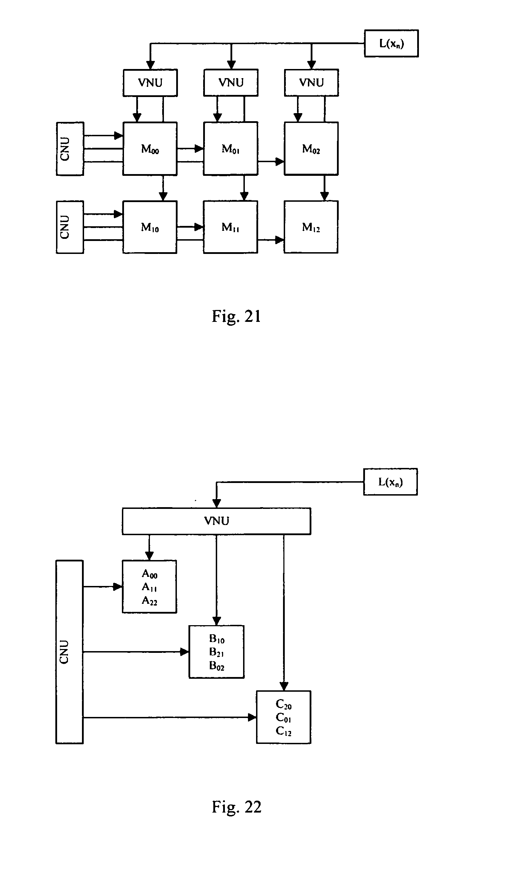

Figs. 20 and 21 show current state of the art for such parallel hardware architectures. The Fig. 20 arrangement operates on a whole row or column simultaneously. That of Fig. 21 operates on multiple rows and multiple columns of the protograph simultaneously. This leads to substantial increases in throughput or reduction in latency compared to a serial implementation. It however comes at a cost of a much more complex memory addressing. In the invention, there is a substantial reduction in this complexity.

The parity check matrix of the invention has more structure than previous approaches. It has the additional property that protograph row m is a cyclic shift of row m-1. This has important implications in deriving low complexity decoder architectures. In non-ring architectures, one of the main problems is to ensure that parallel reads and writes by VNU and CNU processors are directed at separate memories. This is a natural property of the ring protograph. In effect it means that the memory organization in the architecture shown in Fig. 21 reduces from an array of M/R x N/R separate memories to an array of N/R. This has two effects (a) it significantly reduces ASIC routing congestion, (b) fewer larger memories are more area efficient than many small memories.

Consider the 3x3 example below.

$$ RG^T = \begin{bmatrix} A_{00}^T & C_{01}^T & B_{02}^T \\ B_{10}^T & A_{11}^T & C_{12}^T \\ C_{20}^T & B_{21}^T & A_{22}^T \end{bmatrix} $$

The traditional parallel architecture operating on multiple rows and columns simultaneously would have up to NxM memories as previously discussed and shown in Fig. 21. It doesn't exploit the fact that all Axx's are accessed at the same address, and the set {A',B',C'} is addressed by each VNU and each CNU. The memory fragmentation can be reduced by storing all the As, Bs and Cs together in wide memory and distributing to the original memory array locations with wiring as shown below for parallel architectures of the invention..

Fig. 22 shows a memory organisation for a Group-Ring parallel architecture, in which 1 check node processor / variable node processor operates on a whole row or column from the protograph within one cycle.

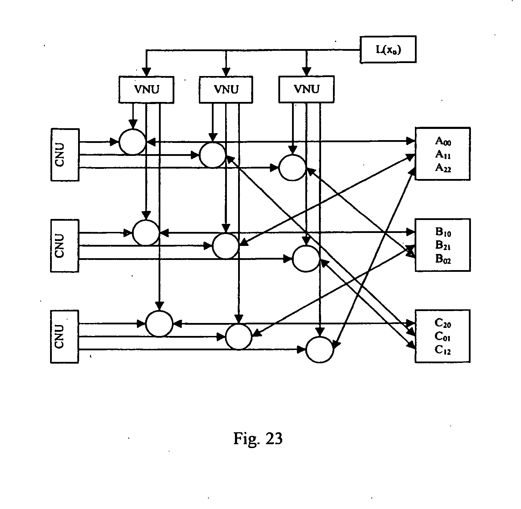

Fig. 23 shows a memory organisation for a Group-Ring parallel architecture, in which M/R check node processors and N/R variable node processors operates on multiple whole rows or columns simultaneously from the protograph within one cycle.

The architecture shown in Fig.23 for example would use 3 physical memories reading and writing a vector of 9 words. For example $A_{00}$, $A_{11}$ and $A_{22}$ are stored at the same address and form a 3 word wide data bus. This allows the 9 messages per cycle to be supplied by 3 physical memories. This brings the memory complexity of such an architectures memory organisation to a similar level to the much simpler vector serial architecture.

Applying the ring structure to the Vector serial architecture allows further parallelism in integer multiples of R, the expansion size. In effect the memory width increases to kxR messages allowing k diagonal protograph entries to be processed at the same time. In the limit as k->N then complete diagonals are processed in a single cycle.

Although the 802.11n protograph is not ring circulant, if we assume it was then the memory architecture for the two ring enhancements can be found. For the Fig 23 architecture, note it can be partitioned into the staircase, which constitutes 2 diagonals, and the remaining 12x12 protograph having 12 diagonals. Together these provide up to 8 column entries. In the table below the performance of a prior approach are shown in the first two columns and that of the invention in the third and fourth columns.

| Architecture | Width (msgs) | Entries | Number |
|---|---|---|---|
| Prior Art Vector Serial | 81 | 88 | 1 |
| Prior Art Parallel | 1 | 81 | 88 |
| Vector serial with invention | 81xk | 88/k | 1 |
| Parallel with invention | 8 | 81 | 14 |

Layered Relief Propagation

Considering the application of Layered Belief Propagation (LBP), the essence of this is that the parity matrix is composed of layers and the check/variable update on one layer is used in the next. This way the extrinsic information improves every layer rather than by iteration. For matrices with lots of layers the convergence time is dramatically improved. The Group Ring matrix has natural layering, where each group row is a layer. The group-ring vector serial architecture doesn't take full advantage of LBP, since it relies on partial processing of several layers per clock cycle. The group-ring architecture in Fig 22 takes full advantage of LBP by processing expansion matrix rows within layers one at a time. The group-ring architecture in Fig 23 can map onto LBP but only by redefining a layer to be row in the expansion matrix.

The memory organisation and addressing benefits of the invention are easy to perform in hardware and have substantial advantages in reducing the ASIC routing congestion. This is particularly relevant in systems requiring large block sizes or very high throughput. The technology is also suitable as an adaptive coding technology, allowing variable code rates and block sizes.

The simplified memory addressing offers substantial reductions in silicon area required for the encoder/decoder (due to reduced routing congestion). The size of the effect on the silicon area is principally dependent on the block size and can vary from 20-50% for 802.11n up for 80-95% for large block size systems. While this in itself does not significantly enhance the architecture's latency or throughput, it can have large benefits for very high throughput systems.

The latency and throughput of the architecture is principally determined by the number of iterations required in the decoding and the invention offers a 10-20% enhancement over current 802.11n and 802.16e standards as seen below. This converts directly into a 20% higher throughput and 20% lower latency, or a further reduction in silicon area required for a desired performance.

Simulation Benchmarking

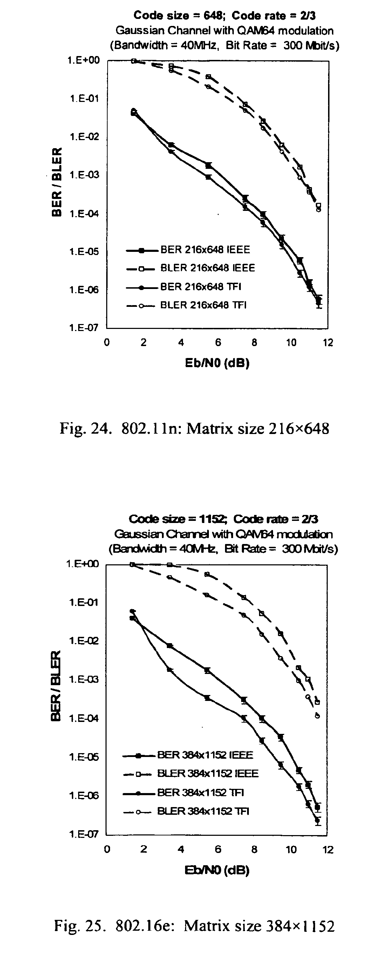

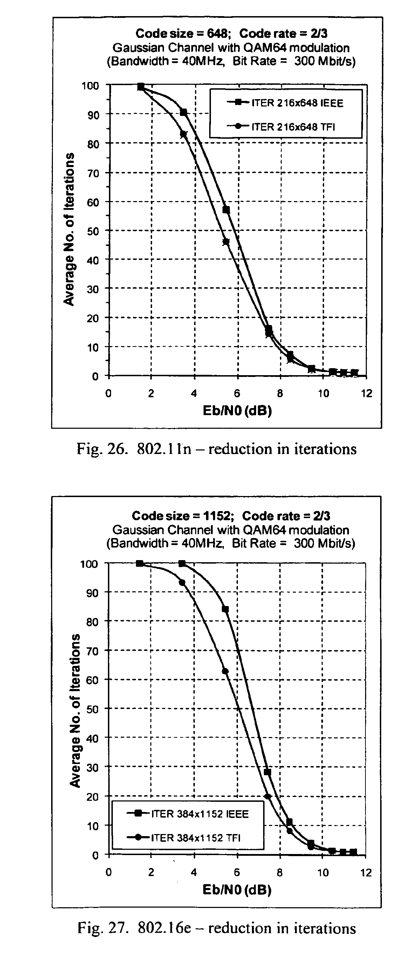

Figs. 24 and 25 below show Bit Error Rate performance of two LDPC codes rapidly generated using the invention and tested through MATLAB-based simulations. The Encoder is the standard LDPC encoder fro MATLAB telecommunications toolbox and the Decoder is a standard iterative LDPC decoder (message passing algorithm) from MATLAB telecommunications toolbox. The last 189 (802.11n) and 336 (802.16e) columns contain a 'staircase' structure which is identical as in the IEEE matrix. The remaining part was generated using an algebraic algorithm which takes 15 (802.11n) and 17 (802.16e) initial parameters as input and can re-create the matrix line-by-line without the need to store the whole structure in memory. Figs. 26 and 27 show iterations versus noise level for both an 802.11n case and an 802.16e case using codes generated by the invention versus the latest standards.

Small Block LDPC Enhanced Performance

While large block LDPC ECC performance can get close to the Shannon limit, small block size LDPC does not perform as well. The invention however delivers substantial BER performance enhancement over current LDPC implementations for small block sizes (up to 1dB observed in benchmarking):

The enhanced performance that is achieved can be used to realise any of the following benefits:

- Reduce the transmitter power by 1dB and achieve the same link performance and range but with longer battery life, about 25% improvement.
- Keep the iterations the same and achieve a longer range and more robust short range.
- Reduce the iterations to achieve the same BER graph as the existing solution. This new architecture is capable of a higher overall throughput.
- Reduce the iterations and remove some parallelism (fewer gates) so the overall decoding time in clock cycles is the same as the existing solution. This new architecture has a lower silicon area and cost.

It will be appreciated that the invention provides substantial design benefits for applications deploying LDPC ECC, including:

- Excellent LDPC BER performance compared to known 802.11n and 802.16e standards.
- Ability to quickly design and generate high performance LDPC matrices to pre-defined properties: code size, code rate and target bit error rate (BER) performance.
- Enabling hardware implementations in serial, vector serial or partially parallel architectures, allowing the technology to be tailored for a wide range of applications, while delivering reduced memory addressing needs and routing complexity compared to existing cyclic LDPC approaches.
- Enabling dynamic and adaptive coding, either just of the code rate or codeword length or potentially fully adaptive.
- LDPC matrix structure enabled decoding by layered belief propagation.

Low encoding latency and high throughput due to lower iteration requirements.

The design benefits of the LDPC matrix generation technology provides the following important commercial benefits:

- Reduced time to market by allowing rapid development of suitable high performance hardware LDPC solutions.

- More efficient memory storage, routing complexity, processing and power budgets relative to known LDPC solutions.
- Fine tuning of the ECC solution to the specific application's requirements potentially as a fully adaptive encoding system.
- Enabling LDPC performance at a fraction of the cost and in applications until now out of LDPC bounds.

The invention can be incorporated into communication (both receivers and transmitters) and storage devices and equipment, possibly embedded into encoding and decoding circuitry. Possible approaches to incorporate the invention into such devices and systems include, amongst others, processor approaches such Application Specific Integrated Circuits (ASICs), Field Programmable Gate Arrays (FGPAs), Digital Signal Processors (DSPs) as well as memory or software based implementations.

Multiple applications can benefit from the invention, such as (but not limited to):

(a) Wireless networks, including Personal Area Networks such as Bluetooth, Local Area Networks such as Wi-Fi, Metropolitan Area Networks such as Wi-Max; Roadside Networks; Digital Radio Networks, Satellite Networks.
(b) High-speed wire-line networks such as Gigabit Ethernet.
(c) Magnetic and Optical storage.

The invention is not limited to the embodiments or applications described but may be varied in construction and detail. For example, in another embodiment transposing is not performed if the mathematical methods of some preceding operations render transposing unnecessary. The invention may be applied to generate a block of a larger matrix such as where a staircase structure is used in encoding. The circuits for implementing the invention may be dedicated hardware or general purpose processors programmed to implement the methods using memory. Also, the invention may be applied to holographic storage.

**Claims**

1.   A method performed by a data processor of an electronic or optical circuit for generation of a Group Ring parity check matrix H (6) for error correction coding, the method comprising the steps of:

(a) choosing a suitable Group-Ring matrix structure containing sub-matrices;
(b) providing initial vectors for each of the sub-matrices by choosing suitable Ring and suitable Group elements;
(c) filling the sub-matrices from each vector according to a row-filling scheme;
(d) filling the Group-Ring matrix structure from the sub-matrices to provide a Group-Ring matrix RG (3); and .
(e) transposing the Group-Ring matrix RG (3) to create the Group-Ring parity check matrix H (6), wherein the method comprises the further step (f) of deleting columns from the Group-Ring matrix RG, and the number of columns deleted is determined by a desired value for the rate, the rate being the target ratio of data in to data out.

2.   A method as claimed in claim 1, wherein in the step (a) the Group-Ring matrix RG has N square sub-matrices in each row and column, N being an integer number.

3.   A method as claimed in either of claims 1 or 2, wherein in the step (a) the RG matrix structure is such that the Group-Ring matrix RG size equals the codeword length.

4.   A method as claimed in any of claims 1 to 3, wherein the number of elements across all of the sub matrices in step (b) provides a low density parity check (LDPC) matrix; and wherein in the step (b) the differences between elements are never repeated, either within a single vector or between vectors.

5.   A method as claimed in any preceding claim, wherein in the step (b) cyclic spacing, defined by length of vector n minus difference, between elements are never repeated, either within a single vector or between vectors; and wherein in the step (b) the number of vectors equals the codeword length divided by the number of sub-matrices.

6.   A method as claimed in any preceding claim, wherein in the step (b) the selection of Group Ring elements constituting the vectors is performed in a pseudo-random way; and wherein in the step (b) the vector elements are chosen within the range of indices of a given sub-matrix from 0 to n-1 inclusive, where n is defined as the code size divided by N; and wherein the step (b) comprises transforming the vectors to a binary form in which each element defines position of 1 in a row vector of n elements.

7. A method as claimed in any preceding claim, wherein the step (c) comprises filling the sub-matrices by use of a linear cyclic operation, wherein each row of a sub matrix is filled from the previous row with the positions cycled forward or backward by an integer number.

8. A method as claimed in any of claims 1 to 7, wherein the step (c) comprises filling the sub-matrices, wherein each row of a sub-matrix is filled from the previous row with the positions cycled forward or backward by an integer value dynamically determined by an equation; and wherein the step (f) is performed in conjunction with steps (a), (b),(c), and (d) in order to achieve a good distance by ensuring that the Group-Ring matrix RG does not have any zero weight columns or rows and a target column weight distribution consisting of a heavy distribution around low column weight values with occasional high weight values is achieved.

9. A method as claimed in any preceding claim, wherein the step (d) comprises making a cyclic arrangement of the sub-matrices.

10. An electronic or optical circuit comprising means for generating a Group-Ring parity check matrix H (6) for error correction coding, by implementing the steps of

(a) choosing a suitable Group-Ring matrix structure containing sub-matrices;
(b) providing initial vectors for each of the sub-matrices by choosing suitable Ring and suitable Group elements;
(c) filling the sub-matrices from each vector according to a row-filling scheme;
(d) filling the Group-Ring matrix structure from the sub-matrices to provide a Group-Ring matrix RG (3); and
(e) transposing the Group-Ring matrix RG (3) to create the Group-Ring parity check matrix H (6),
(f) deleting columns from the Group-Ring matrix RG (3), in which the number of columns deleted is determined by a desired value for the rate, the rate being the target ratio of data in to data out.

11. A circuit as claimed in claim 10, wherein the circuit comprises shift registers for continuous cyclic shifting of binary vectors for step (c), and a counter controlling operation of the shift registers; and wherein the circuit comprises counters keeping track of positions of non-zero elements of binary vectors, and the processor is adapted to increment the counters to create each next row.

12. A circuit as claimed in claim 11, wherein the circuit is adapted to increment the counters in a non-linear manner; and wherein the circuit is adapted to decrement the counters.

13. A circuit as claimed in any of claims 10 to 12, wherein the circuit is adapted to perform step (b) in a manner whereby differences between elements are never repeated, either within a single vector or between vectors.

14. A circuit as claimed in any of claims 10 to 13, wherein the circuit is adapted to perform step (b) in a manner whereby cyclic spacing, defined by length of vector n minus difference, between elements are never repeated, either within a single vector or between vectors.

15. A method for data encoding or decoding, the method comprising the steps of:

(i) receiving initial vectors calculated from row vectors of a Group-Ring parity check matrix H generated by a method of any of claims 1 to 9;
(ii) cyclic shifting the vectors to generate a desired output row of the Group-Ring parity check matrix H;
(iii) re-arranging the operation order of the vectors depending on the RG matrix structure and the chosen row;
(iv) operating on the vectors on information to be encoded; and
(v) repeating steps (ii) to (iv) for the next row of the Group-Ring parity check matrix H.

16. A method as claimed in claim 15, wherein for step (ii) the circuit adds an additional cyclic shift each time a deleted column is reached, thus creating a row based on the next non-deleted column; and wherein for steps (i) and (ii) vectors are converted into counters, each of which stores the location of an element of a vector.

17. A method as claimed in claim 16, wherein a counter tracks the position of each of the 1s directly and the counter block sizes are integer powers of 2 as the binary counters automatically reset themselves at the end of each cycle; and wherein the counters are incremented or decremented by a desired shift corresponding to the next desired row.

18. An electronic or optical circuit for encoding or decoding, the circuit being adapted to perform the steps of :

(i) receiving initial vectors calculated from row vectors of a Group-Ring parity check matrix H generated by a circuit of any of claims 10 to 14;

(ii) cyclic shifting the vectors to generate a desired output row of the Group-Ring parity check matrix H;

(iii) re-arranging the operation order of the vectors depending on the chosen row of the and the RG matrix structure

(iv) operating with the vectors on information to be encoded; and

(v) repeating steps (ii) to (iv) for the next desired row of the Group-Ring parity check matrix H.

19. A circuit as claimed in claim 18, wherein for step (ii) the circuit is adapted to add an additional cyclic shift each time a deleted column is reached, thus creating a row based on the next non-deleted column.

20. A circuit as claimed in either of claims 18 or 19, wherein the circuit comprises counters and is adapted to perform steps (i) and (ii) by converting vectors into counter values, each of which stores the location of an element of a vector.

21. A circuit as claimed in claim 20, wherein the circuit comprises a counter adapted to track the position of each of 1s directly and the counter block sizes are integer powers of 2 as the binary counters automatically reset themselves at the end of each cycle.

22. A circuit as claimed in claims 20 or 21, wherein the counters are incremented or decremented by a desired shift corresponding to the next desired row.

23. A circuit as claimed in either of claims 18 or 19, wherein the circuit comprises a shift register and step (ii) is performed by the shift register.

24. A communication device for generating a forward error correction data stream, the device comprising a circuit of any of claims 10 to 14 or 18 to 23 for encoding or decoding.

25. A computer readable memory used to store a program for performing a method of any of claims 1 to 9 or 15 to 17 when said program is executed on a digital processor.

**Patentansprüche**

1. Verfahren, das von einem Datenprozessor einer elektronischen oder optischen Schaltung zum Erzeugen einer Gruppe-Ring-Paritätsprüfmatrix H (6) zur Fehlerkorrekturcodierung ausgeführt wird, wobei das Verfahren die folgenden Schritte beinhaltet:

(a) Wählen einer geeigneten Gruppe-Ring-Matrixstruktur, die Submatrizen enthält;

(b) Bereitstellen von Anfangsvektoren für jede der Submatrizen durch Wählen von geeigneten Ring- und geeigneten Gruppenelementen;

(c) Ausfüllen der Submatrizen von jedem Vektor gemäß einem Reihenfüllschema;

(d) Ausfüllen der Gruppe-Ring-Matrixstruktur von den Submatrizen zum Gewinnen einer Gruppe-Ring-Matrix RG (3); und

(e) Transponieren der Gruppe-Ring-Matrix RG (3) zum Erzeugen der Gruppe-Ring-Paritätsprüfinatrix H(6),

wobei das Verfahren den weiteren Schritt (f) des Löschens von Spalten aus der Gruppe-Ring-Matrix RG beinhaltet und wobei die Zahl der gelöschten Spalten anhand eines gewünschten Wertes für die Rate ermittelt wird, wobei die Rate das Zielverhältnis zwischen Eingangsdaten und Ausgangsdaten ist.

2. Verfahren nach Anspruch 1, wobei in Schritt (a) die Gruppe-Ring-Matrix RG N quadratische Submatrizen in jeder Reihe und Spalte hat, wobei N eine ganze Zahl ist.

3. Verfahren nach Anspruch 1 oder 2, wobei in Schritt (a) die RG-Matrixstruktur derart ist, dass die Größe der Gruppe-Ring-Matrix RG gleich der Codewort-Länge ist.

4. Verfahren nach einem der Ansprüche 1 bis 3, wobei die Zahl der Elemente über alle Submatrizen in Schritt (b) eine Paritätsprüfinatrix geringer Dichte (LDPC) bereitstellt und wobei in Schritt (b) die Differenzen zwischen Elementen niemals wiederholt werden, ob in einem einzelnen Vektor oder zwischen Vektoren.

5. Verfahren nach einem der vorherigen Ansprüche, wobei in Schritt (b) eine zyklische Beabstandung, definiert durch die Länge von Vektor n minus Differenz, zwischen Elementen niemals wiederholt wird, ob innerhalb eines einzelnen Vektors oder zwischen Vektoren; und wobei in Schritt (b) die Anzahl von Vektoren gleich der Codewort-Länge dividiert durch die Anzahl von Submatrizen ist.

6. Verfahren nach einem der vorherigen Ansprüche, wobei in Schritt (b) die Auswahl von die Vektoren bildenden Gruppe-Ring-Elementen auf eine pseudozufällige Weise erfolgt; und wobei in Schritt (b) die Vektorelemente innerhalb des Indexbereichs einer gegebenen Submatrix von 0 bis n-1 einschließlich gewählt werden, wobei n als die Code-Größe dividiert durch N definiert ist; und wobei Schritt (b) das Transformieren der Vektoren in eine binäre Form beinhaltet, in der jedes Element Position von 1 in einem Reihenvektor von n Elementen definiert.

7. Verfahren nach einem der vorherigen Ansprüche, wobei Schritt (c) das Ausfüllen der Submatrizen mit Hilfe einer linearen zyklischen Operation beinhaltet, wobei jede Reihe einer Submatrix von der vorherigen Reihe ausgefüllt wird, wobei die Positionen um eine ganze Zahl nach vorne oder hinten zykliert werden.

8. Verfahren nach einem der Ansprüche 1 bis 7, wobei Schritt (c) das Ausfüllen der Submatrizen beinhaltet, wobei jede Reihe einer Submatrix von der vorherigen Reihe ausgefüllt wird, wobei die Positionen um einen ganzzahligen Wert nach vorne oder hinten zykliert werden, der durch eine Gleichung dynamisch bestimmt wird; und wobei Schritt (f) in Verbindung mit den Schritten (a), (b), (c) und (d) ausgeführt wird, um eine gute Distanz zu erzielen, indem gewährleistet wird, dass die Gruppe-Ring-Matrix RG keine Null-Gewichtungsspalten oder -reihen hat und eine Ziel-Spaltengewichtungsverteilung erzielt wird, die aus einer schweren Verteilung um niedrige Spaltengewichtungswerte mit gelegentlichen hohen Gewichtungswerten besteht.

9. Verfahren nach einem der vorherigen Ansprüche, wobei Schritt (d) das Vornehmen einer zyklischen Anordnung der Submatrizen beinhaltet.

10. Elektronische oder optische Schaltung, die Mittel zum Erzeugen einer Gruppe-Ring-Paritätsprüfmatrix H (6) zur Fehlerkorrekturcodierung beinhaltet, durch Ausführen der folgenden Schritte:

    (a) Wählen einer geeigneten Gruppe-Ring-Matrixstruktur, die Submatrizen enthält;
    (b) Bereitstellen von Anfangsvektoren für jede der Submatrizen durch Wählen geeigneter Ring- und geeigneter Gruppenelemente;
    (c) Ausfüllen der Submatrizen von jedem Vektor gemäß einem Reihenfüllschema;
    (d) Ausfüllen der Gruppe-Ring-Matrixstruktur von den Submatrizen zum Bereitstellen einer Gruppe-Ring-Matrix RG (3); und
    (e) Transponieren der Gruppe-Ring-Matrix RG (3) zum Erzeugen der Gruppe-Ring-Paritätsprüfmatrix H(6),
    (f) Löschen von Spalten aus der Gruppe-Ring-Matrix RG (3), in der die Zahl der gelöschten Spalten durch einen gewünschten Wert für die Rate bestimmt wird, wobei die Rate das Zielverhältnis zwischen Eingangsdaten und Ausgangsdaten ist.

11. Schaltung nach Anspruch 10, wobei die Schaltung Schieberegister zum kontinuierlichen zyklischen Verschieben von binären Vektoren für Schritt (c) und einen Zähler zum Steuern des Betriebs der Schieberegister umfasst; und wobei die Schaltung Zähler umfasst, die die Positionen von Nicht-Null-Elementen von Binärvektoren verfolgen, und wobei der Prozessor die Aufgabe hat, die Zähler zum Erzeugen jeder nächsten Reihe zu inkrementieren.

12. Schaltung nach Anspruch 11, wobei die Schaltung die Aufgabe hat, die Zähler auf nichtlineare Weise zu inkrementieren; und wobei die Schaltung die Aufgabe hat, die Zähler zu dekrementieren.

13. Schaltung nach einem der Ansprüche 10 bis 12, wobei die Schaltung die Aufgabe hat, Schritt (b) auf eine solche Weise auszuführen, dass Differenzen zwischen Elementen niemals wiederholt werden, ob innerhalb eines einzelnen Vektors oder zwischen Vektoren.

14. Schaltung nach einem der Ansprüche 10 bis 13, wobei die Schaltung die Aufgabe hat, Schritt (b) auf eine solche Weise auszuführen, dass eine zyklische Beabstandung, definiert durch die Länge von Vektor n minus Differenz, zwischen Elementen niemals wiederholt wird, ob innerhalb eines einzelnen Vektors oder zwischen Vektoren.

15. Verfahren zur Datencodierung oder -decodierung, wobei das Verfahren die folgenden Schritte beinhaltet:

(i) Empfangen von Anfangsvektoren, die von Reihenvektoren einer Gruppe-Ring-Paritätsprüfmatrix H berechnet wurden, die mit einem Verfahren nach einem der Ansprüche 1 bis 9 erzeugt wurde;
(ii) zyklisches Verschieben der Vektoren zum Erzeugen einer gewünschten Ausgangsreihe der Gruppe-Ring-Paritätsprüfmatrix H;
(iii) Umordnen der Betriebsreihenfolge der Vektoren je nach der RG-Matrixstruktur und der gewählten Reihe;
(iv) Arbeiten mit den Vektoren an zu codierenden Informationen; und
(v) Wiederholen der Schritte (ii) bis (iv) für die nächste Reihe der Gruppe-Ring-Paritätsprüfmatrix H.

16. Verfahren nach Anspruch 15, wobei für Schritt (ii) die Schaltung bei jedem Erreichen einer gelöschten Spalte eine zusätzliche zyklische Verschiebung hinzufügt, so dass eine Reihe auf der Basis der nächsten nicht gelöschten Spalte entsteht; und wobei für Schritte (i) und (ii) Vektoren in Zähler umgewandelt werden, von denen jeder den Ort eines Elementes eines Vektors speichert.

17. Verfahren nach Anspruch 16, wobei ein Zähler die Position jeder der Einsen direkt verfolgt und die Zählerblockgrößen ganzzahlige Potenzen von 2 sind, da die binären Zähler sich am Ende jedes Zyklus selbst automatisch zurückstellen; und wobei die Zähler durch eine gewünschte Verschiebung entsprechend der nächsten gewünschten Reihe inkrementiert oder dekrementiert werden.

18. Elektronische oder optische Schaltung zum Codieren oder Decodieren, wobei die Schaltung die Aufgabe hat, die folgenden Schritte auszuführen:

(i) Empfangen von Anfangsvektoren, die von Reihenvektoren einer Gruppe-Ring-Paritätsprüfmatrix H berechnet werden, die von einer Schaltung nach einem der Ansprüche 10 bis 14 erzeugt wird;
(ii) zyklisches Verschieben der Vektoren zum Erzeugen einer gewünschten Ausgangsreihe der Gruppe-Ring-Paritätsprüfmatrix H;
(iii) Umordnen der Betriebsreihenfolge der Vektoren je nach der gewählten Reihe der [*sic*] und der RG-Matrixstruktur;
(iv) Arbeiten mit den Vektoren an zu codierenden Informationen; und
(v) Wiederholen der Schritte (ii) bis (iv) für die nächste gewünschte Reihe der Gruppe-Ring-Paritätsprüfmatrix H.

19. Schaltung nach Anspruch 18, wobei für Schritt (ii) die Schaltung die Aufgabe hat, bei jedem Erreichen einer gelöschten Spalte eine zusätzliche Zyklusverschiebung hinzuzufügen, so dass eine Reihe auf der Basis der nächsten nichtgelöschten Spalte erzeugt wird.

20. Schaltung nach Anspruch 18 oder 19, wobei die Schaltung Zähler umfasst und die Aufgabe hat, die Schritte (i) und (ii) durch Umwandeln von Vektoren in Zählerwerte auszuführen, von denen jeder den Ort eines Elementes eines Vektors speichert.

21. Schaltung nach Anspruch 20, wobei die Schaltung einen Zähler umfasst, der die Position jeder der Einsen direkt verfolgt, und wobei die Zählerblockgrößen ganzzahlige Potenzen von 2 sind, da sich die binären Zähler am Ende jedes Zyklus selbst automatisch zurückstellen.

22. Schaltung nach Anspruch 20 oder 21, wobei die Zähler durch eine gewünschte Verschiebung entsprechend der nächsten gewünschten Reihe inkrementiert oder dekrementiert werden.

23. Schaltung nach Anspruch 18 oder 19, wobei die Schaltung ein Schieberegister umfasst und Schritt (ii) durch das Schieberegister ausgeführt wird.

24. Kommunikationsgerät zum Erzeugen eines Vorwärts-Fehlerkorrekturdatenstroms, wobei das Gerät eine Schaltung nach einem der Ansprüche 10 bis 14 oder 18 bis 23 zum Codieren oder Decodieren umfasst.

25. Rechnerlesbarer Speicher zum Speichern eines Programms zum Ausführen eines Verfahrens nach einem der Ansprüche 1 bis 9 oder 15 bis 17, wenn das genannte Programm auf einem digitalen Prozessor ausgeführt wird.

**Revendications**

1. Un procédé exécuté par un processeur de données d'un circuit optique ou électronique destiné à la génération d'une matrice de contrôle de parité Groupe-Anneau H (6) pour un codage de correction d'erreurs, le procédé comprenant les opérations suivantes :

   (a) le choix d'une structure de matrice Groupe-Anneau adaptée contenant des sous-matrices,
   (b) la fourniture de vecteurs initiaux pour chacune des sous-matrices par le choix d'éléments Groupe et d'éléments Anneau adaptés,
   (c) le remplissage des sous-matrices à partir de chaque vecteur selon un mécanisme de remplissage de ligne,
   (d) le remplissage de la structure de matrice Groupe-Anneau à partir des sous-matrices de façon à fournir une matrice Groupe-Anneau RG (3), et
   (e) la transposition de la matrice Groupe-Anneau RG (3) de façon à créer la matrice de contrôle de parité Groupe-Anneau H (6),

où le procédé comprend l'opération complémentaire (f) de suppression de colonnes de la matrice Groupe-Anneau RG, et le nombre de colonnes supprimées est déterminé par une valeur souhaitée pour le débit, le débit étant le rapport cible de données en entrée sur données en sortie.

2.  Un procédé selon la Revendication 1, où à l'opération (a) la matrice Groupe-Anneau RG possède N sous-matrices carrées dans chaque ligne et colonne, N étant un nombre entier.

3.  Un procédé selon l'une quelconque des Revendications 1 ou 2, où à l'opération (a) la structure de matrice RG est telle que la taille de la matrice Groupe-Anneau RG est égale à la longueur de mot de code.

4.  Un procédé selon l'une quelconque des Revendications 1 à 3, où le nombre d'éléments sur toutes les sous-matrices à l'opération (b) fournit une matrice de contrôle de parité à faible densité (LDPC), et où à l'opération (b) les différences entre éléments ne sont jamais répétées, ni à l'intérieur d'un vecteur unique ni entre vecteurs.

5.  Un procédé selon l'une quelconque des Revendications précédentes, où à l'opération (b) les espacements cycliques, définis par la longueur du vecteur n moins la différence entre éléments, ne sont jamais répétées, ni à l'intérieur d'un vecteur unique ni entre vecteurs, et où à l'opération (b) le nombre de vecteurs est égal à la longueur de mot de code divisée par le nombre de sous-matrices.

6.  Un procédé selon l'une quelconque des Revendications précédentes, où à l'opération (b) la sélection d'éléments Groupe-Anneau constituant les vecteurs est exécutée d'une manière pseudo-aléatoire, et où à l'opération (b) les éléments de vecteur sont choisis à l'intérieur de la plage d'indices d'une sous-matrice donnée de 0 à n-1 compris, où n est défini comme étant la taille de code divisée par N, et où l'opération (b) comprend la transformation des vecteurs en une forme binaire dans laquelle chaque élément définit la position de 1 dans un vecteur ligne de n éléments.

7.  Un procédé selon l'une quelconque des Revendications précédentes, où l'opération (c) comprend le remplissage des sous-matrices au moyen d'une opération cyclique linéaire, où chaque ligne d'une sous-matrice est remplie à partir de la ligne précédente avec les positions cyclées vers l'avant ou vers l'arrière par un nombre entier.

8.  Un procédé selon l'une quelconque des Revendications 1 à 7, où l'opération (c) comprend le remplissage des sous-matrices, où chaque ligne d'une sous-matrice est remplie à partir de la ligne précédente avec les positions cyclées vers l'avant ou vers l'arrière par une valeur entière déterminée dynamiquement par une équation, et où l'opération (f) est exécutée conjointement avec les opérations (a), (b), (c) et (d) afin d'atteindre une bonne distance en garantissant que la matrice Groupe-Anneau RG ne possède aucune colonne ou ligne à poids nul et une distribution de poids de colonnes cible se composant d'une distribution lourde autour de valeurs de poids de colonne faibles avec des valeurs de poids élevées occasionnelles est obtenue.

9.  Un procédé selon l'une quelconque des Revendications précédentes, où l'opération (d) comprend la fabrication d'un agencement cyclique des sous-matrices.

10. Un circuit optique ou électronique comprenant un moyen de générer une matrice de contrôle de parité Groupe-Anneau H (6) pour un codage de correction d'erreurs par la mise en oeuvre des opérations suivantes :

   (a) le choix d'une structure de matrice Groupe-Anneau adaptée contenant des sous-matrices,
   (b) la fourniture de vecteurs initiaux pour chacune des sous-matrices par le choix d'éléments Groupe et d'éléments Anneau adaptés,

(c) le remplissage des sous-matrices à partir de chaque vecteur selon un mécanisme de remplissage de ligne,

(d) le remplissage de la structure de matrice Groupe-Anneau à partir des sous-matrices de façon à fournir une matrice Groupe-Anneau RG (3), et

(e) la transposition de la matrice Groupe-Anneau RG (3) de façon à créer la matrice de contrôle de parité Groupe-Anneau H (6),

(f) la suppression de colonnes de la matrice Groupe-Anneau RG (3), où le nombre de colonnes supprimées est déterminé par une valeur souhaitée pour le débit, le débit étant le rapport cible de données en entrée sur données en sortie.

11. Un circuit selon la Revendication 10, où le circuit comprend des registres à décalage pour un décalage cyclique continu de vecteurs binaires pour l'opération (c), et un compteur commandant le fonctionnement des registres à décalage, et où le circuit comprend des compteurs qui suivent des positions d'éléments non nuls de vecteurs binaires, et le processeur est adapté de façon à incrémenter les compteurs de façon à créer chaque ligne suivante.

12. Un circuit selon la Revendication 11, où le circuit est adapté de façon à incrémenter les compteurs d'une manière non linéaire, et où le circuit est adapté de façon à décrémenter les compteurs.

13. Un circuit selon l'une quelconque des Revendications 10 à 12, où le circuit est adapté de façon à exécuter l'opération (b) d'une manière telle que les différences entre éléments ne sont jamais répétées, ni à l'intérieur d'un vecteur unique ni entre vecteurs.

14. Un circuit selon l'une quelconque des Revendications 10 à 13, où le circuit est adapté de façon à exécuter l'opération (b) d'une manière telle que les espacements cycliques, définis par la longueur du vecteur n moins la différence entre éléments, ne sont jamais répétés, ni à l'intérieur d'un vecteur unique ni entre vecteurs.

15. Un procédé de codage et de décodage de données, le procédé comprenant les opérations suivantes :

(i) la réception de vecteurs initiaux calculés à partir de vecteurs lignes d'une matrice de contrôle de parité Groupe-Anneau H générée par un procédé selon l'une quelconque des Revendications 1 à 9,

(ii) le décalage cyclique des vecteurs de façon à générer une ligne de sortie souhaitée de la matrice de contrôle de parité Groupe-Anneau H,

(iii) le réagencement de l'ordre de fonctionnement des vecteurs en fonction de la structure de matrice RG et la ligne choisie,

(iv) le traitement des vecteurs sur des informations à coder, et

(v) la répétition des opérations (ii) à (iv) pour la ligne suivante de la matrice de contrôle de parité Groupe-Anneau H.

16. Un procédé selon la Revendication 15, où pour l'opération (ii) le circuit ajoute un cycle de décalage additionnel chaque fois qu'une colonne supprimée est atteinte, créant ainsi une ligne basée sur la colonne non supprimée suivante, et où, pour les opérations (i) et (ii), des vecteurs sont convertis en compteurs, chacun d'eux conservant en mémoire l'emplacement d'un élément d'un vecteur.

17. Un procédé selon la Revendication 16, où un compteur suit la position de chacun des 1 directement et les tailles de bloc des compteurs sont des puissances entières de 2, puisque les compteurs binaires se réinitialisent automatiquement à la fin de chaque cycle, et où les compteurs sont incrémentés ou décrémentés par un décalage souhaité correspondant à la ligne souhaitée suivante.

18. Un circuit optique ou électronique destiné au codage et au décodage, le circuit étant adapté de façon à exécuter les opérations suivantes :

(i) la réception de vecteurs initiaux calculés à partir de vecteurs lignes d'une matrice de contrôle de parité Groupe-Anneau H générée par un circuit selon l'une quelconque des Revendications 10 à 14,

(ii) le décalage cyclique des vecteurs de façon à générer une ligne de sortie souhaitée de la matrice de contrôle de parité Groupe-Anneau H,

(iii) le réagencement de l'ordre de fonctionnement des vecteurs en fonction de la ligne choisie de la et *[sic]* de la structure de matrice RG,

(iv) le traitement des vecteurs sur des informations à coder, et

(v) la répétition des opérations (ii) à (iv) pour la ligne souhaitée suivante de la matrice de contrôle de parité Groupe-Anneau H.

19. Un circuit selon la Revendication 18, où pour l'opération (ii) le circuit est adapté de façon à ajouter un cycle de décalage additionnel chaque fois qu'une colonne supprimée est atteinte, créant ainsi une ligne basée sur la colonne non supprimée suivante.

20. Un circuit selon l'une quelconque des Revendications 18 ou 19, où le circuit comprend des compteurs et est adapté de façon à exécuter les opérations (i) et (ii) en convertissant des vecteurs en valeurs de compteur, chacun d'elles contenant l'emplacement d'un élément d'un vecteur.

21. Un circuit selon la Revendication 20, où le circuit comprend un compteur adapté de façon à suivre la position de chacun des 1 directement et les tailles de bloc des compteurs sont des puissances entières de 2, puisque les compteurs binaires se réinitialisent automatiquement à la fin de chaque cycle.

22. Un circuit selon l'une quelconque des Revendications 20 ou 21, où les compteurs sont incrémentés ou décrémentés par un décalage souhaité correspondant à la ligne souhaitée suivante.

23. Un circuit selon l'une quelconque des Revendications 18 ou 19, où le circuit comprend un registre de décalage et l'opération (ii) est exécutée par le registre de décalage.

24. Un dispositif de communication destiné à générer un train de données de correction d'erreur sans circuit de retour, le dispositif comprenant un circuit selon l'une quelconque des Revendications 10 à 14 ou 18 à 23 destiné au codage et au décodage.

25. Une mémoire lisible par ordinateur utilisée pour conserver en mémoire un programme destiné à exécuter un procédé selon l'une quelconque des Revendications 1 à 9 ou 15 à 17, lorsque ledit programme est exécuté sur un processeur numérique.

Fig. 1

*Example:*    *N=4*

*V1_binary = zeros(1,n);   V1_binary(49) = 1;*

*V2_binary = zeros(1,n);   V2_binary(36)=1;   V2_binary(31)=1;*

*V3_binary = zeros(1,n);   V3_binary(19)=1;*

*V4_binary = zeros(1,n);   V4_binary(1)=1;      V4_binary(34)=1;*
*V4_binary(12)=1*

Fig. 2(a)

1

*V1_binary*          *V2_binary*          *V3_binary*          *V4_binary*

2

A          B          C          D

RG

3

Fig. 2(b)

Fig. 3

Fig. 4

Fig. 5

RG – code1     RG – code2

H – code1     H – code2

Fig. 6

Fig. 7

H − code1a

H − code1b

Fig. 8 Two parity-check matrices created on the basis of the same RG matrix:
Code1a − standard deletion pattern; Code1b − modified deletion pattern.

Fig. 9 Column (left graph) and row (right graph) weight distributions for Code1a and
Code1b.

Fig. 10. Performance comparison for code1a (squares) and code1b (circles).

**Pattern1:**

```
      A               B               C               D
0                 1                 1             1
   1                 0                 1            1
      1                 1             0               1
         1                 1                          0
            0                 1    1                     1
               1                 1    1                    1
                  1           1     1                        1
                     1     1             1       0
```

Using a standard cyclic row-filling method, the above example would look as follows:

```
      A               B               C               D
1                 1                 1             1
   1                 1                 1            1
      1                 1                 1         1
         1                 1          1               1
            1                 1    1                     1
               1                 1    1                    1
                  1           1     1                        1
                     1     1             1    1
```

Fig. 11

RG – code3

H – code3a

H – code3b

H – code3c

Fig. 12

**(A)**

**(B)**

Fig. 13

Fig. 14

**Pattern2:**

**Pattern3:**

Fig. 15

Fig. 16

Fig. 17

Fig. 18

```
           ┌──────────────────────────┐
           │   Initial vectors (N)    │
           │      V_A ... V_N         │
           │ code size (M) and rate (R)│
           └──────────────────────────┘
                       │
                       ↓
                ┌──────────────┐
         ┌─────→│  V_N (1xM/N) │        ↰
         │      └──────────────┘    Repeat N times
   ┌──────────┐        │
   │  Cycle   │   ┌──────────────┐
   │Control(C)│──→│Shift Register│
   └──────────┘   │ based on C,R │
                  └──────────────┘
                       │
                       ↓
              Output N times per row
```

Control Cycle
Contains row and column
distribution parameters

Fig. 19

```
                ┌─────┐    ┌───────┐
                │ VNU │←───│ L(x_n)│
                └─────┘    └───────┘
        ┌────┐  ┌─────┐  ┌─────┐  ┌─────┐
        │CNU │  │M_00 │→ │M_01 │→ │M_02 │
        └────┘  └─────┘  └─────┘  └─────┘
                ┌─────┐  ┌─────┐  ┌─────┐
                │M_10 │→ │M_11 │→ │M_12 │
                └─────┘  └─────┘  └─────┘
```

Fig. 20

Fig. 21

Fig. 22

Fig. 23

Fig. 24.  802.11n: Matrix size 216×648

Fig. 25.  802.16e:  Matrix size 384×1152

Fig. 26. 802.11n – reduction in iterations

Fig. 27. 802.16e – reduction in iterations

## EP 2 176 758 B1

**Patent documents cited in the description**

- WO 2006117769 A
- US 20070033480 A
- WO 2004019268 A
- WO 02103631 A, Flarion